# EUROPEAN PATENT SPECIFICATION

(11) **EP 3 050 117 B1**
(45) Date of publication and mention of the grant of the patent: **29.08.2018**
(21) Application number: 13770488.8
(22) Date of filing: 27.09.2013
(51) Int. Cl.: H01L 31/02, H02H 3/18

(54) **COMBINER BOX OF A DC PART OF A PV PLANT**
COMBINERBOX FÜR DEN DC-TEIL EINER PV-ANLAGE
BOÎTIER DE RACCORDEMENT POUR LA PARTIE DC D'UNE INSTALLATION PHOTOVOLTAÏQUE

(43) Date of publication of application: 03.08.2016
(73) Proprietor: ABB Schweiz AG, 5400 Baden (CH)
(72) Inventor: STRASSEL, Thorsten, 5243 Mülligen (CH); GATI, Rudolf, 5507 Mellingen (CH); ABPLANALP, Markus, 5405 Baden-Dättwil (CH); DE ROO, Harm, 78224 Singen OT Bohlingen (DE); WULF, Thomas, 88662 Überlingen (DE)
(74) Representative: ABB Patent Attorneys
(86) International application number: PCT/EP2013/070258
(87) International publication number: WO 2015/043663

(56) References cited:
- EP-A1- 2 626 712
- NOT PROCESSED ED - WIP-RENEWABLE ENERGIES: EU PVSEC PROCEEDINGS : 25TH EUROPEAN PHOTOVOLTAIC SOLAR ENERGY CONFERENCE AND EXHIBITION / 5TH WORLD CONFERENCE ON PHOTOVOLTAIC ENERGY CONVERSION, 6-10 SEPTEMBER 2010, VALENCIA, SPAIN, MUNICH, DE, 6 September 2010 (2010-09-06), XP040531758, ISBN: 978-3-936338-26-3

## Description

### FIELD OF THE INVENTION

The invention relates to a box for combining n strings or m arrays of a DC (direct current) part of a PV (photovoltaic) plant with n strings or m arrays, wherein n and m are integers greater 2.

The combiner box can be realized as a string combiner box. The box then combines the n strings, wherein each of the n strings includes serially connected PV modules for generating a direct current and wherein each of the n strings further comprises a power line electrically connected to one of the PV modules at a first end and a return line electrically connected to another of the PV modules at a second end. Such a string combiner box comprises:
a plurality of n DC inputs for electrical connection to the n strings,
a DC output for electrical connection to at least one of an inverter or an array combiner box of the DC part,
a power line busbar which is electrically connected to power line terminals of the n DC inputs by means of n first power line connections and to a power line terminal of the DC output by means of a second power line connection,
a return line busbar which is electrically connected to return line terminals of the n DC inputs by means of n first return line connections and to a return line terminal of the DC output by means of a second return line connection,
a plurality of n pairs of first switching units, one member of each pair being arranged in one of the n first power line connections and another member of each pair in a corresponding one of the n first return line connections,
a plurality of at least n DC direction sensors for detecting the direction of direct currents conducted in the n first power line connections or in the n first return line connections, wherein each sensor is associated to at least one member of a pair of the first switching units, and
a combiner control unit for tripping the first switching units,

in which the DC direction sensors communicate their output signals to the combiner control unit.

The combiner box can also be realized as an array combiner box. The box then combines the m arrays. Each of the m arrays includes n strings of m×n strings (m by n strings) of the m arrays and one of m string combiner boxes. The connection between the m arrays resp. the DC outputs of the m string combiner boxes is realized by means of m cables. Such an array combiner box comprises:
a plurality of m DC inputs for electrical connection to the m arrays,
a DC output for electrical connection to the inverter,
a power line busbar which is electrically connected to power line terminals of the m DC inputs by means of m first power line connections and to a power line terminal of the DC output by means of a second power line connection,
a return line busbar which is electrically connected to return line terminals of the m DC inputs by means of m first return line connections and to a return line terminal of the DC output by means of a second return line connection,
a plurality of m pairs of first switching units, one member of each pair being arranged in one of the m first power line connections and another member of each pair in a corresponding one of the m first return line connections,
a plurality of at least m DC direction sensors for detecting the direction of direct currents conducted in the m first power line connections or in the m first return line connections, wherein each sensor is associated to at least one member of a pair of the first switching units, and
a combiner control unit for tripping the first switching units,
in which the DC direction sensors communicate their output signals to the combiner control unit.

At least one of the string combiner box and the array combiner box can comprise a box-shaped enclosure which supports the n or m DC inputs and the DC output and which encases components, like the switching units, the busbars and the line connections. However, the string and/or the array combiner box need no box-shaped enclosure and can be installed in a cabinet encasing the inverter. Such a cabinet can comprise not only the string and/or the array combiner box and the power electronics of the inverter but also an AC part of the PV plant including transformers and switchgear. Thus, the cabinet of such a central inverter can integrate the string and/or the combiner box and thus can comprise a plurality of DC inputs formed from the DC inputs of the string and/or array combiner box.

### BACKGROUND OF THE INVENTION

Power plants owners have become more and more cost-oriented due to the ongoing reduction of feed-in tariffs for electric power. Together with an ever increasing competition of an increasing number of component suppliers, PV component prices are under a constant pressure. An important differentiator - besides the price - lies in the contribution of the components to ensure the yield rate of the PV plant. Thus for circuit breakers in the DC part, it is not only the fault handling capability of the protection equipment, but the functionality to disconnect faulty or under-performing parts of the PV modules in order to keep the plant operational in an optimal mode. In this way the circuit breakers contribute in ensuring a high plant yield.

At present the DC circuit breakers are in price range where only in large PV plants with central inverters they are used for the plant control together with remote servo units. Else PV fuses are dominating when it comes to a fault current protection, due to their low costs. This advantage seems to outperform the benefit of an increased yield rate which is possible when using the more expensive DC breakers.

A significant cost reduction of the electromechanical PV DC breakers is not foreseeable in the near future. In the majority of the available products, the design is derived from standard AC circuit breakers in order to benefit from the larger production volume. The disadvantage is that with increasing DC system voltage, more and more breaker poles must be connected in series. Despite the increasing volume, an appropriate interruption performance in the low current regime is hard to ensure. Thus a general scaling law for the number of poles in series with the system voltage cannot be stated. A remote operation of those breakers via a PV plant control needs additional external components.

The interruption of a fault current on the DC side in PV plants is challenging mainly due for two reasons:
a) In a direct current (i.e. a current with no natural zero crossing) at a voltage level of up to 1 kV there is a need to build-up a counter voltage of up to 2 kV in order to enforce a current zero crossing.
b) PV generator or a string (i.e. a collection of PV modules) cannot be switched off, i.e. even stray light at night produces a voltage.

Two additional particularities of PV generation are double-edged:
c) Short-circuit current is limited to about 125% of peak nominal current.
d) Trend to extended series connection of modules in order to obtain higher DC voltages (1.5kVDC) and thus reduced nominal currents.

Said short-current limitation mentioned in item c) is advantageous since the high peak fault currents of inductive grid components like transformers or generators do not need to be handled. The disadvantage resides in the increased effort for the detection of a fault. Since the current value is also affected by factors like incident solar radiation and ambient temperature to which the PV modules are exposed the current may be below a maximum rated current in case of a fault, for example, such that a sound window available for any fault current detection may be quite narrow in terms of boundaries and constraints. As a result, the distinction between an fault current at low irradiation and nominal current at high irradiation requires additional effort in terms of sensors and electronic logic.

The tendency to higher DC voltages comes at the expense that present electromechanical breakers increase in size and cost despite of a decrease of nominal currents for a given plant size.

A combiner box comprising the features of the introductory part of claim 1 and 5 is described in EP 2 626 712 A1. The combiner box comprises a plurality of pairs of circuit breakers. Each member of a pair is arranged in a power resp. in a return line connection between a DC input for a string and a power resp. a return line busbar. The combiner box further comprises reverse current detectors which communicate to a monitor. The monitor is configured to open a pair of the plurality of circuit breakers, when for reason of a faulty string which is electrically connected to this pair of circuit breakers, the associated reverse current sensor detects a reverse current. The reverse current is the sum of the currents generated in the remaining faultless strings and a further reverse current which is fed through a DC output from an inverter. The further reverse current is limited with a fuse, however the residual reverse currents which are generated from the faultless strings must be broken with the pair of circuit breakers which electrically connect the faulty string to a power and to a return line busbar. Thus each pair of the plurality of pairs of circuit breakers must be sized to break a current which is a multiple of the nominal current of a string.

A DC part for a photovoltaic plant with a string combiner box according to the first part of claim 1 is described in prior art documents, like WO 2007/048421 A2, US 2011/0031814A1, US 2012/0126626 A1 and EP 2 463 977 A2. These DC parts comprise switching units for protecting the PV plant. These DC switching units are realized either as fuses or as large sized switches.

In a PV plant the tripping point is close to the nominal current, which means that there is an increased on-state loss by design limitations of the fuses. The selection of the tripping point has to consider an additional margin for the variation of the ambient temperature, since the surrounding of the fuses is typically heated by the sun easily to 70°C. Furthermore, in large PV plants the time consuming replacement of the fuses is less economical than the usage of remotely controlled circuit breakers. Besides, fuses cannot be remotely operated in order to clear a ground fault. Furthermore, losses of fuses are higher in general.

Large sized switches increase the costs of a PV plant considerably.

### SUMMARY OF THE INVENTION

It is therefore an object of the invention to provide a combiner box of the DC part for a PV plant according to the introductory part of claims 1 and 2 which allows a fast localization and removal of a faulty string or array, which improves the yield rate of the PV plant and which can be manufactured, operated and maintained in a cost-efficient manner.

These and other objects are achieved with the combiner boxes according to claims 1 and 2.

The combiner box according to claim 1 comprises a pair of second switching units, one member of which being arranged in the second power line connection and another member of which being arranged in the second return line connection, and the combiner control unit is configured
to communicate a first tripping signal to the first switching units for opening n-1 or m-1 of the n or m pairs of first switching units in order to interrupt the direct currents between each of n-1 or m-1 DC inputs and the two busbars when in a remaining one of the DC inputs the direct current changes from a forward to a first reverse current,
to communicate the first tripping signal without any time delay to the pair of second switching units in order to open these switching units and to break a second reverse current fed through the DC output, and
to communicate a second tripping signal for opening the pair of first switching units associated to the remaining DC input with a first time delay, wherein the first time delay is at least the time required for breaking the second reverse current.

The combiner control box according to claim 2 an array combiner box for use in a DC part, in which no further array combiner boxes are provided and the combiner control unit is configured
to communicate a first tripping signal to the first switching units for opening n-1 or m-1 of the n or m pairs of first switching units in order to interrupt the direct currents between each of n-1 or m-1 DC inputs and the two busbars when in a remaining one of the DC inputs the direct current changes from a forward to a first reverse current, and
to communicate a second tripping signal for opening the pair of first switching units associated to the remaining DC input with a first time delay depending on the discharge of the filter capacitors of the inverter.

In the combiner boxes according to claim 1 and according to claim 2
the detection of the direction of the DC currents in the n or m DC inputs resp. in the n strings or m arrays and an appropriate action sequence in the combiner box allow a fast localization and removal of a faulty string resp. of a faulty array in the PV plant. The first switching units only have to break a direct current in the order of the nominal current of just one of the n strings resp. m arrays. Thus, the first switching units can be small-sized and the PV plant can be operated without any remarkable interruption. Furthermore the PV plant is distinguished by a high yield rate, a high availability and can be manufactured and operated in a cost-efficient manner.

In a PV plant, in which the power or the return line of the DC part is connected to ground, n DC direction sensors are sufficient for the fast localization and removal of the faulty string or of the faulty array.

In a PV plant, in which neither the power nor the return line of the DC part is connected to ground, the combiner box can comprise a plurality of n or m pairs of DC direction sensors, wherein each sensor is associated to one of the first switching units.

In order to ensure a cost-efficient design and a high availability of the combiner box at least one member of each of the n or m pairs of first switching units can be realized as a hybrid breaker. The other member of each of the n or m pairs of first switching units can be realized as an electromechanical disconnector. Furthermore, the members of each of the n or m pairs of first switching units can be realized as hybrid breakers. The term hybrid breaker is understood as a mechanical switch that is connected in parallel to a semiconductor switch.

The combiner box according to claim 1 comprises the pair of second switching units, one member of which being arranged in the second power line connection and another member of which being arranged in the second return line connection. Each member of the pair of second switching units can be realized as an electromechanical circuit breaker or as a disconnector.

In order to remove a faulty string or array quickly from the PV plant the combiner control unit of the combiner box according to claim 1 communicates the first tripping signal without any time delay to the pair of second switching units in order to open these switching units and to break the second reverse current fed through the DC output and communicates a second tripping signal for opening the pair of first switching units associated to the remaining DC input with a first time delay, wherein the first time delay is at least the time required for breaking the second reverse current.

Since in the combiner box according to claim 5 the DC output is applied for electrical connection to the inverter and since in the DC part no further strings resp. no further arrays are provided which feed into the inverter such a combiner box does not need any second switching unit. In the case of a string combiner box the faulty string resp. in the case of an array combiner box the faulty array including a faulty cable between a string combiner box and the array combiner box can be disconnected with the pair of the first switching first units which is associated to the faulty string respectively to the faulty array after a time delay depending on the discharge of the filter capacitors of the inverter.

In an embodiment, in which the combiner box is realized as a string combiner box and comprises a string combiner control unit as the combiner control unit, the n pairs of first switching units and the pair of second switching units, the string combiner control unit communicates the first tripping signal to the n-1 pairs of first switching units and the pair of second switching units without any time delay with respect to the detection of the first reverse current.

In an embodiment, in which the combiner box is realized as an array combiner box and comprises an array combiner control unit as the combiner control unit, the m pairs of first switching units and the pair of second switching units, the array combiner control unit communicates the first tripping signal to the m-1 pairs of first switching units and the pair of second switching units instead of without any time delay with a time delay with respect to the detection of the first reverse current, when the first reverse current still continues after the time delay, wherein the time delay is at least the time required for disconnecting a faulty string and a string combiner box of a faulty array which by means of a cable is connectable to the remaining DC input of the array combiner box.

In a preferred embodiment of the invention the combiner box can further comprise n or m pairs of local control units, wherein each local unit is associated to one of the first switching units,
each DC direction sensor can communicate its output signals to at least one associated member of a pair of the n or m pairs of local control units,
at least one associated member of a pair of the n or m pairs of local control units can communicate the output signals of the associated DC direction sensor to the combiner control unit, and
the local control unit can communicate the first tripping signals and any further data signal to the associated first switching unit.

In such an embodiment of the invention the combiner control unit and each of the local control units can comprise a control member for the delay and release of the first tripping signal and any further data signal.

The combiner box can comprise a rail arrangement and a plurality of box-shaped modules attached to the rail arrangement.

In a further embodiment of such a combiner box a first module of the plurality of modules can comprise
a single switching unit of the n or m pairs of the first switching units,
a section of the power or the return line connection passing the first module between an input and an output terminal,
a single DC direction sensor of the at least n or m DC direction sensors,
a local control unit of the plurality of n or m pairs of local control units for receiving data signals from the single DC direction sensor and the single switching unit and for transmitting data signals to the single switching unit, and a data interface for communicating data signals between its logic control unit and the combiner control unit.

The first module can further comprise a manual operation switch for enabling the input of manually generated data signals and for the display of manually requested data signals.

In a further embodiment of such a combiner box a second module of the plurality of modules can comprise the pair of second switching units and can be realized as a multi-pole rail mountable circuit breaker having at least two circuit breaker poles and a remote switch unit for controlling the pair of second switching units,
in which at least one first breaker pole of the at least two circuit breaker poles forms a first member of the pair of second switching units, which first member is arrangeable in the second power line connection and comprises a terminal for receiving an end of a first section of the second power line connection coming from a module and another terminal for receiving an end of a second section of the second power line connection at the DC output, and
in which at least one second breaker pole of the circuit breaker poles forms a second member of the pair of second switching units, which second member is arrangeable in the second return line connection and comprises another terminal for receiving an end of a first section of the second return line connection coming from a module and another terminal for receiving an end of a second section of the second return line connection at the DC output, and
in which the combiner control unit transmits the first tripping signal to the remote switch unit.

In a further embodiment of such a combiner box a third module of the plurality of modules can comprise the power resp. the return line busbar, n or m terminals for electrically connecting the power resp. the return line terminals of the n or m DC inputs to the power resp. to the return line busbar and a terminal for electrically connecting the power resp. the return line busbar to the power resp. to the return line terminal of the DC output.

In a further embodiment of such a combiner box a fourth module of the plurality of modules can comprise the combiner control unit and a data interface for communicating data signals between the combiner control unit and the n or m pairs of local logic units.

The fourth module can comprises a manual operation switch for enabling the input of manually generated signals to the combiner control unit and the display of manually requested data signals.

### BRIEF DESCRIPTION OF THE DRAWINGS

Exemplary embodiments of the DC part of a photovoltaic plant according to the invention are shown in figures as follows:
- fig.1: is a schematic circuit diagram of a first embodiment of the DC part of the photovoltaic plant according to the invention comprising four strings and a string combiner box,
- fig.2: is an enlarged view of the string combiner box shown in fig.1,
- fig.3: is a timing scheme illustrating current characteristics in the string combiner box shown in figures 1 and 2 during the interruption of a current in a faulty one of the four strings,
- fig.4: is a circuit diagram of a hybrid breaker used in the string combiner box shown in fig.1,
- figures 5 and 6: are schematic circuit diagrams of a second and a third embodiment of the DC part of the photovoltaic plant according to the invention, each embodiment comprising three string combiner boxes according to fig.2, an array combiner box and three cables electrically connecting the three string combiner boxes to the array combiner box,
- fig.7: is an enlarged view of the array combiner box shown in fig.6,
- fig.8: is a top view of a mechanical layout of the circuit diagram according to fig.1,
- figures 9 to 11: three different modules of the mechanical layout according to fig.8, and
- fig.12: a sequence illustrating the communication in the string combiner box shown in figures 1 and 2 and configured as shown in figures 8 to 11 during the interruption of a fault current in a faulty one of the four strings.

The reference signs used in the figures and their meaning are summarized in a list of reference signs. Generally, alike or alike-functioning parts are given the same reference signs. The described embodiment is meant as example and shall not confine the invention.

### WAY TO IMPLEMENT THE INVENTION

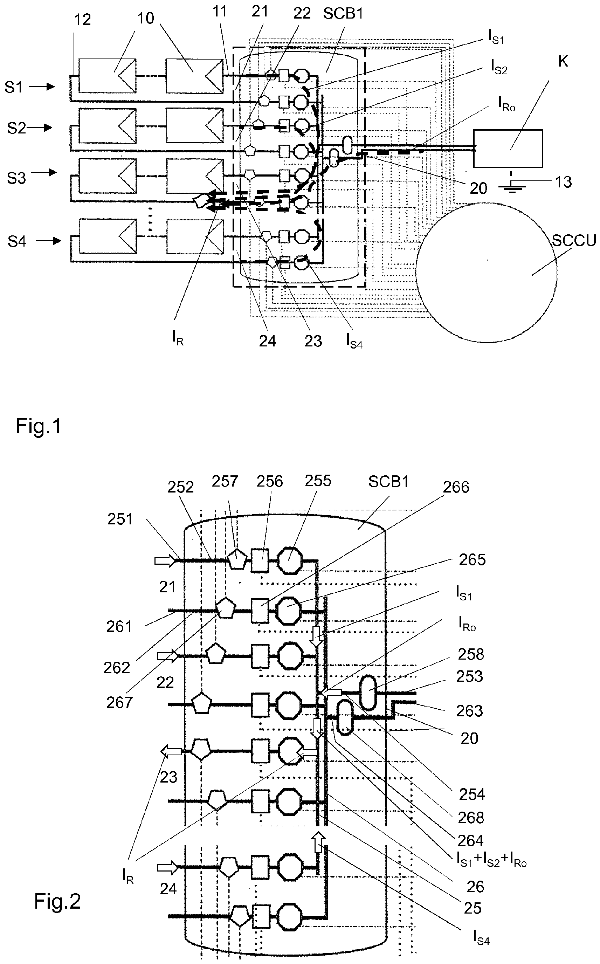

Each of the three embodiments of the DC part of a photovoltaic plant shown in figures 1, 5 and 6 comprise four strings S1, S2, S3, S4 and a string combiner box SCB1. The plurality of the strings is not limited to four and can be an integer n greater 2.

Each string includes a plurality of serially connected PV modules 10 for generating a DC current and forming a first and a second end. Each string further comprises a power 11 and a return line 12 (reference signs only given to string S1). The power line 11 is electrically connected to the first end and the return line 12 the second end of the serial connection of the modules 10.

Figures 1 and 2 illustrate that the string combiner box SCB1 comprises four DC inputs 21, 22, 23 resp. 24 for electrical connection to a respective one of the four strings S1, S2, S3 resp. S4 and a DC output 20 for electrical connection to a DC input of a further component K of the photovoltaic plant, in particular a DC-AC inverter or an array combiner box.

As shown in fig.2 the string combiner box SCB1 further comprises a power line busbar 25 and a return line busbar 26. The power line busbar 25 is electrically connected to power line terminals 251 of the four DC inputs 21, 22, 23, 24 by means of four power line connections 252 and to a power line terminal 253 of the DC output 20 by means of a power line connection 254. The return line bus bar 26 is electrically connected to four return line terminals 261 of the four DC inputs 21 to 24 by means of four return line connections 262 and to a return line terminal 263 of the DC output 20 by means of a return line connection 264.

In each of the four power line connections 252 resp. in each of the four corresponding return line connections 262 is arranged a member 255 resp. 265 of just one pair of four pairs of switching units 255, 265, a DC direction sensor 256 resp. 266 and a potential-to-ground sensor 257 resp. 267. In the power line connection 254 and in the corresponding esp. in the return line connection 264 is arranged a switching unit 258 resp. 268.

The string combiner box SCB1 further comprises a string combiner control unit SCCU for receiving output signals from the DC direction sensors 256 and 266 and from the potential-to-ground sensors 257 and 267. The string combiner control unit SCCU is enabled to generate tripping signals for opening or closing the switching units 255 and 265 in function of the outputs of the sensors 256, 266, 257 and 267.

The DC part of the PV plant according to fig.1 is for use in a PV plant in which neither the power line 11, the power line busbar 25 or any further power line section nor the return line 12, the return line busbar 26 or any further return line section is connectable to ground. During operation each of its four strings S1 to S4 feeds a direct current Iᵢ, i= S1, S2, S3 and S4, via the string combiner box SCB1 to the component K. The size of the direct current is typically in the range of 8A to 30A but can be as high as 120A. The instantaneous electrical power generation from incident solar radiation by the PV modules 10 leads to a limited short circuit current in the order of the nominal current of the PV modules, typically 125% of the nominal current. Thus each pair of the eight switching units 255, 265, which break or make a current circuit, have to carry a direct current generated in one of the four strings, for instance S1, must only carry the direct current Iᵢ which is sized in the order of the nominal current of the string.

However, when a fault occurs between the terminals of a string, as shown in the figures 1 and 2 for instance in string S3, a short current will flow into the string S3. The short circuit current is fed from the three faultless parallel strings S1, S2 and S4 with the direct current I_{S1}, I_{S2} and I_{S4}. These three direct currents pass the DC input 23 as a direct current I_{R} with a reverse direction with respect to the DC inputs 21, 22 and 24. In addition parallel string combiner boxes can feed into the fault from outside a reverse current I_{Ro} via an array combiner box or via the input stage of the inverter. The inverter itself can feed the fault, too, e.g. by the discharge of its filter capacitors. Thus the reverse current I_{R} in the faulty string S3 is the sum of the currents I_{S1}, I_{S2}, I_{S4} and the reverse current I_{Ro}.

The string combiner control unit SCCU permanently receives output signals from the DC direction sensors 256 and 266. Upon the detection of the reverse current in the power 252 and the return line connection 262, connected to the DC input 23 which feeds the fault in the string S3, the string combiner control unit SCCU generates (mechanically or electronically) a tripping signal and emits this signal to six of the eight switching units 255 and 265 in order to interrupt the direct currents I_{S1}, I_{S2} and I_{S4} generated in the faultless strings S1, S2 and S4. Independently the switching units 258 und 268 which are preferably realized as conventional circuit breakers detect the reverse current I_{Ro} (or an overcurrent) and interrupt the reverse current I_{Ro} fed from outside (component K: array combiner box, inverter) in the string combiner box SCB1. These two conventional circuit breakers can take up to 5 ms for interruption. During this time the two switching units 255 and 265 which are arranged in the fault path must carry the reverse current I_{Ro} fed from outside. Only after all other switching units 255 , 265, 258 and 268 have interrupted their currents, the two switching units 255 and 265 which have taken the reverse current I_{R} of the faulty string S3 are operated (preferably after a fixed time delay of 5ms, but an additional mechanical or electronic activation is possible as well). Thus these two switching units need not to turn-off any current. After an additional fixed time delay given by the switching time of the two switching units 258 and 268 in the fault path, all remaining switching units 255, 265, 258 and 268 can (automatically) close again and normal operation of the remaining faultless three strings S1 , S2 and S4 is recovered. The overall operation time can be in the order of 10 ms.

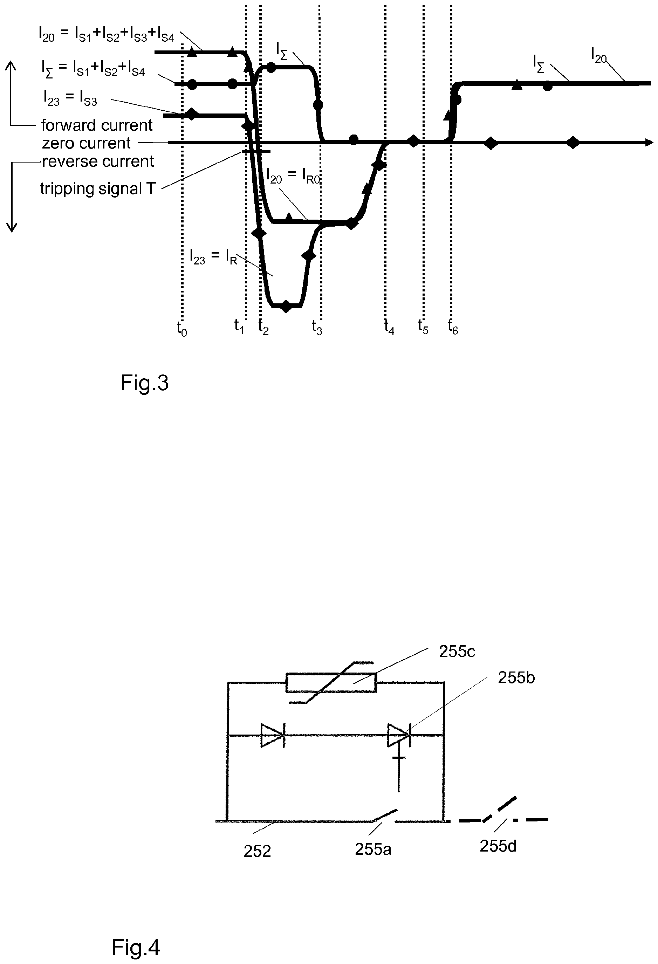

The sequence of actions to clear the afore-mentioned fault in the string S1 can be taken from the timing scheme according to fig.3, in which action times tᵢ, with i=0, 1, 2,..,6, in function of the current I₂₃ through the DC input 23 and thus through two switching units 255 and 265 which protect the string S3, the current I_{Σ} = I_{S1}+I_{S2}+I_{S4} through the DC inputs 21, 22, 24 and thus through the six switching units 255 and 265 which protect the strings S1, S2 and S4, and the current I₂₀ through the DC output 20 and thus to the inverter or to an array combiner box are shown. The current profile of I_{Σ} is indicated by the line with bullet markers and drafted as positive graph representing the absolute current fed by the non-faulty strings or arrays, depending on the embodiment. The current profile of I₂₀ is indicated by the line with trident markers and whereas the current profile of I₂₃ is indicated by the line with diamond markers.
t₀ The current I_{S3} generated in the string S3 determines the current I₂₃ through the DC input 23. The sum of all four currents I_{S1}, I_{S2}, I_{S3} and I_{S4} generated in the four strings S1, S2, S3 and S4 determines the current I₂₀ through the DC output 20.
t₁ Occurrence of a fault in the string S3, here assumed to be a line-to line-fault.
t₂ The current I₂₃ through the DC input 23 changes its direction and now flows as the reverse current I_{R} shown in figures 1 and 2. Also the current I₂₀ through the DC output 23 changes its direction and now flows as the reverse current I_{R0} shown in figures 1 and 2. Detection of the reverse current I_{R} (fig.2) due to the fault in the string S3 by means of two DC direction sensors 256 and 266. The sensors 256 and 266 detect the direction of the reverse current I_{R} in the power and the return line connection 252, 262 connected to the DC input 23 and thus to the fault string S3. Concurrent detection of the outside reverse current resp. the overcurrent I_{Ro} (fig.2) by the switching units 258, 268. The string combiner control unit SCCU generates a first tripping signal T for opening the parallel six switching units 255, 265 which are connected via the DC inputs 21, 22, 24 to the faultless strings S1, S2 and S4. The first tripping signal simultaneously is provided for opening the switching units 258 and 268. The switching units 255, 265 which are connected via the DC input 23 to the faulty string S3 are not tripped and remain closed. I_{Σ} raises in between t₁ and t₂ about 25 % since the limited short circuit current in the PV modules measures typically 125% of the nominal current.
t₃ The parallel switching units 255, 265 which are connected via the DC inputs 21, 22 and 24 to the faultless strings S1, S2 and S4 have interrupted the direct current I_{S1}, I_{S2} and I_{S4} generated in the faultless strings S1, S2 and S4. The switching units 255, 265 which are connected via the DC output 20 to the faulty string S3 still remain closed.
t₄ The switching units 258 and 268 interrupt the reverse current I_{Ro} from downstream (inverter, possible parallel arrays) with a time delay with respect to the afore-mentioned six switching units 255, 265.
t5 The string combiner control unit SCCU generates a second tripping signal for opening the two switching units 255 and 265 which are connected via the DC input 23 to the fault string S3 after a fixed first time delay or after a signal from the switching units 258 and 268. As a consequence these two switching units isolate the faulty string S3 from the two busbars 25 and 26 such that the faulty string S3 can be removed from the DC input 23.
t6 The string combiner control unit SCCU generates a third tripping signal for reconnecting the six parallel switching units 255, 265 which protect the DC inputs 21, 22, 24 and thus the faultless strings S1, S2, S4. This tripping signal acts on the switching units 258, 268 after an additional time delay. Now, the strings S1, S2 and S4 feed the DC part of the PV plant again with the same current as at t₀. Since the faulty string S3 is disconnected at t₄ the resulting current I₂₀ available at the DC output 20 after t₆ comprises the remaining currents I_{S1} I_{S2} and I_{S4} only such that the overall DC current level I₂₀ is lower after t₆ than before t₁.

The switching units 255, 258, 265 and 268 protecting the parallel strings S1 to S4 are coordinated in such a way, that they switch-off the forward currents I_{S1}, I_{S2} and I_{S4} firstly. Thus the faultless strings S1, S2 and S4 do not feed any reverse current into the fault anymore. In case of an simple embodiment of the DC part of the photovoltaic plant, in particular, when the component K is realized as the inverter (and no further strings are provided) the faulty string S3 can be disconnected without current after a given time delay. Then the two switching units 255 and 265 are opened after a time delay depending on the discharge of the filter capacitors of the inverter, after some, typically 5, ms. Thus the switching units 255 and 265 only have to break or have to make a circuit charged with a direct current in the order of the nominal current of just one of the strings S1, S2, S3 or S4. Thus these switching units can be small-sized.

The detecting of the direction of the DC currents of the four strings S1 to S4 in the DC inputs 21 to 24 allows a fast localization and removal of a fault string without any remarkable interruption of the PV device and with small-sized switching units 255 and 265. Thus the PV plant is distinguished by a high availability and can be manufactured and operated in a cost-efficient manner.

For reason of technical and economic benefits it is to recommend to realize the two members of each of the pairs of switching units 255 and 265 as uni- or bipolar hybrid breakers. The DC direction sensors 256 and 266 can be realized as Hall element and the potential-to-ground sensors 257 and 267 as voltage dividers.

As shown in fig.4 a hybrid breaker, for instance used as switching unit 255, can be realized as unidirectional hybrid breaker and comprises a nominal path with controllable mechanical contacts 255a which serve as nominal contacts of the hybrid breaker. Such hybrid breakers are known. The nominal path of the hybrid breaker is arranged in one of the power 252 or return line connections 262, here in power line connection 252. The hybrid breaker further comprises a switch-off path with a serial connection of a diode and a controllable semiconductor switch 255b, typically an IGBT, which path is connected in parallel to the mechanical contacts 255a and to a dissipation path comprising a non-linear resistive element, preferably a varistor 255c. The electrical energy of the hybrid breaker can be supplied from at least one of a switching arc and an external power source.

The string currents are typically in the range of 8A to 30A but can be as high as 120A, which discrete semiconductors 255b can still handle. The blocking voltage of the semiconductor switch 255b is matched to the parallel varistor 255c, preferably to 2-3 times the system voltage which equals approx. 4.5kV for a 1.5kV system. For this voltage class IGBTs are the most favorable components having the additional benefit of being voltage controlled (gate voltage -5V...+15V). Since an IGBT is reverse conducting, the diode in the switch-off path provides the reverse blocking capability. In order to avoid an thermal overload by dissipating the fault energy in the semiconductor 255b the parallel varistor 255c is needed (a larger silicon area is not cost-efficient for such a purpose). The nominal contacts 255a carry the current during normal operation and commutate it to the switched- off path in case of a fault. The nominal contacts 255a need to carry some kA overcurrent and eventually make the nominal current. If necessary the nominal contacts 255a can be replaced with an electronic relay or with a miniature circuit breaker.

In such a switching unit a fault current breaking process is started with a tripping signal which causes the mechanical contacts 255a to separate and to commutate the current to the semiconductor switch path in which the current is interrupted by means of turning off the semiconductor switch 255b. A fast rising overvoltage caused by the inductances of the grid is limited in the varistor 255c which dissipates the energy of the fault current and which brings the fault current to zero. Then the hybrid breaker blocks the nominal system voltage. An additional mechanical disconnector, here the switching unit 255d, is opened as soon as the fault current is interrupted. The open disconnector 255d ensures galvanic isolation (leakage currents) as well as lightning impulse withstand.

In the afore-described embodiment according to fig.1 neither the power line of the DC part, typically comprising the power line 11, the power line busbar 25 and any further power line section arranged in the component K, nor the return line of the DC part, typically comprising the return line 12, the return line busbar 26 and any further return line section arranged in the component K, is connected to ground. However, when the DC part according to fig.1 is used in a PV plant in which either the power or the return line of the DC part is connected to ground 4 resp. n DC direction sensors 256 or 266 instead of 4 resp. n pairs of DC direction detectors 256, 266 are required. These 4 resp. n DC direction sensors are sufficient to localize the faulty string and to cause the removal of the same. A connection 13 for grounding the power or the return line of the DC part of the PV plant is shown with dashed lines in fig. 1. This connection is provided at the component K, typically the inverter, and connects the power or the return line conductor of the DC part to ground.

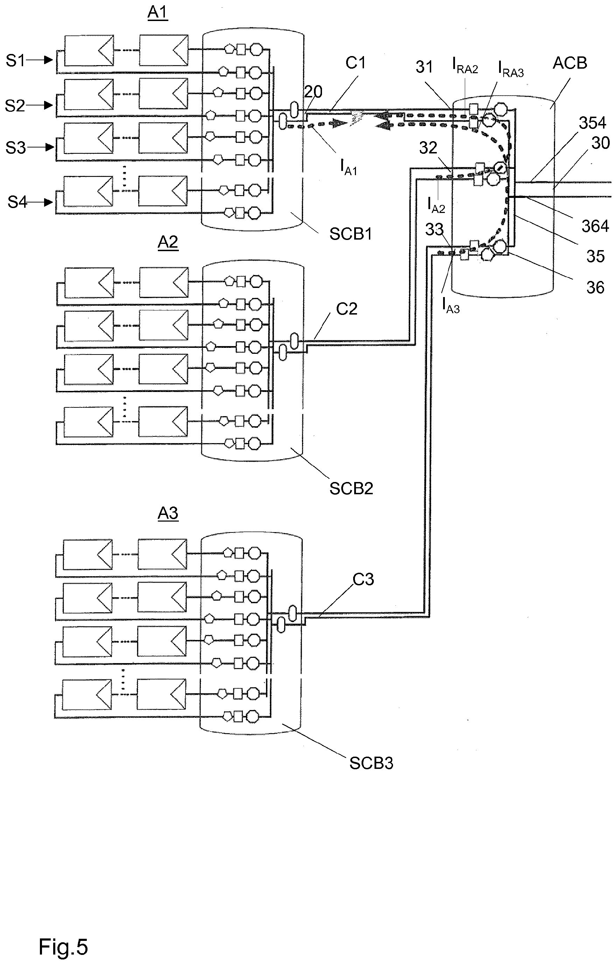

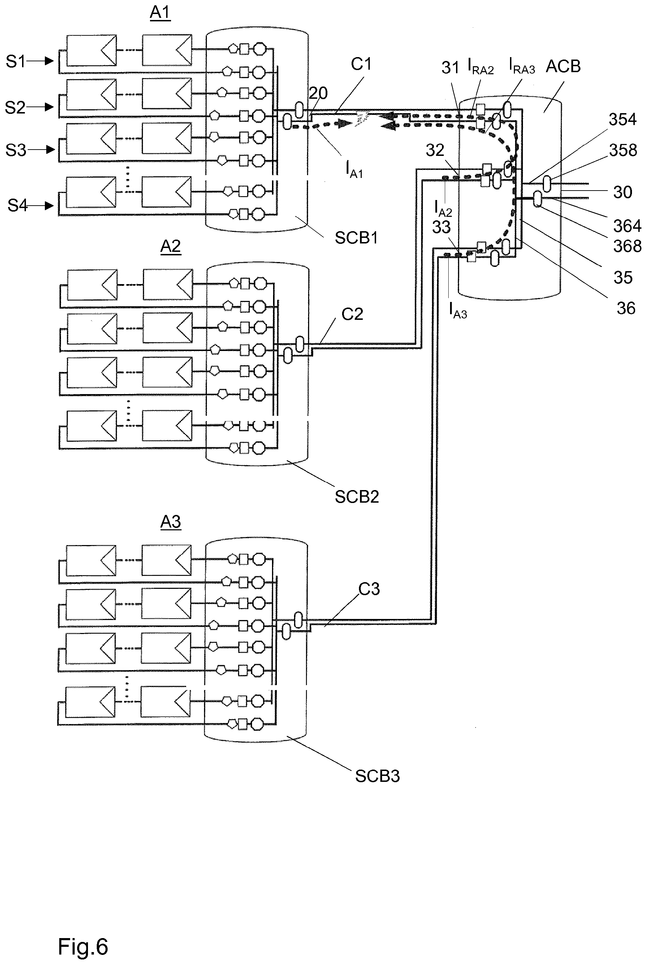

In the embodiments according to figures 5 and 6 the DC part includes three arrays A1, A2 and A3, an array combiner box ACB and three cables C1, C2 and C3, which connect three DC outputs of the three string combiner boxes in parallel. The array A1 comprises the four strings S1 to S4 and the string combiner box SCB1 of the afore-described embodiment of the DC part of a photovoltaic plant. The arrays A1 to A3 are largely identical, but also can have different designs. Instead of four strings at least one of the arrays A1 to A3 can comprise only three or more than four strings.

The cable C1 connects the output 20 of the string combiner box SCB1 resp. the array A1 with a DC input 31 of the array combiner box ACB, whereas the cable C2 connects the DC output (not marked) of the array A2 resp. its string combiner box SCB2 to an DC input 32 of the array combiner box ACB and the cable C3 the DC output (not marked) of the array A3 resp. its string combiner box SCB3 to a DC input 33 of the array combiner box ACB.

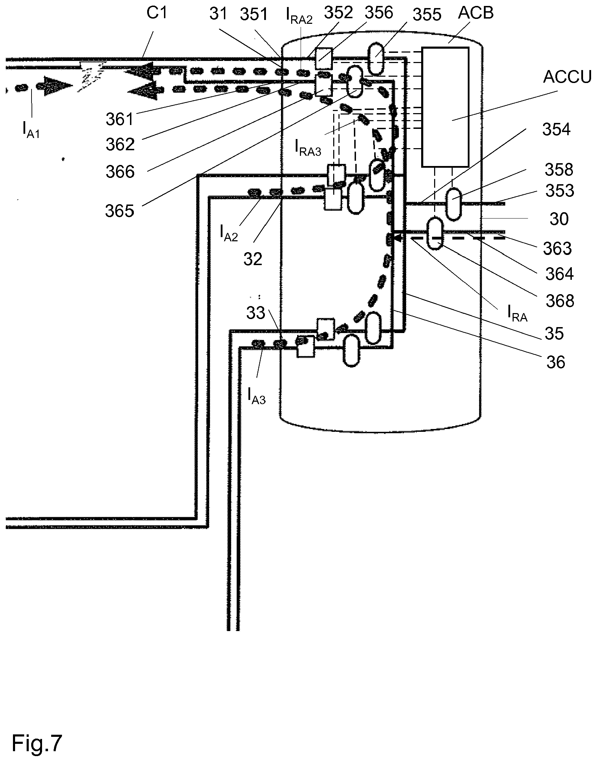

The array combiner box ACB shown in figures 5 and 6 further comprises a power line busbar 35 and a return line busbar 36. Fig.7 shows that power line busbar 35 is electrically connected to power line terminals 351 of the three DC inputs 31, 32, 33 by means of three power line connections 352 and to a power line terminal 353 of the DC output 30 by means of a power line connection 354. The return line bus bar 36 is electrically connected to three return line terminals 361 of the three DC inputs 31 to 33 by means of three return line connections 362 and to a return line terminal 363 of the DC output 30 by means of a return line connection 364. In each of the three power line connections 352 resp. in each of the three return line connections 362 is arranged a switching unit 355 resp. 365 and a DC direction sensor 356 resp. 366.

In the embodiment of the array combiner box ACB shown in fig. 5 the power line connection 354 resp. the return line connection 364 connects the power line busbar 35 resp. the return line busbar 36 directly to the DC output 30, whereas in the embodiment shown in fig.6 a switching unit 358 resp. 368 is arranged in the power line connection 354 resp. in the return line connection 364.

During operation the three arrays A1 to A3 feed direct currents I_{A1}, I_{A2}, I_{A3} via one of the cables C1 to C3 and the array combiner box ACB to the inverter. The size of the nominal current of the arrays depends on the number n of strings and can be in the order of one kA. The instantaneous electrical power generation from incident solar radiation by the PV modules 10 leads to a limited short circuit current in the order of the nominal current of the PV modules, typically 125% of the nominal current.

When a fault occurs in the cable C1 DC currents pass the DC input 32 resp. 33 as forward current I_{A2} resp. I_{A3}, the DC output 20 of the array A1 as forward current I_{A1} and the DC input 31 of the array combiner box ACB as reverse current I_{RA2} and I_{RA3}.

In the embodiment according to fig.5 each of the six switching units 355 and 365 is realized as electromechanical circuit breaker and typically can handle DC voltages up to some kV and DC currents up to a few kA. As soon as the fault occurs in cable C1 the two DC direction detectors 356 and 366, guarding the DC input 31, detect the reverse current I_{RA2} and I_{RA3} and emit a tripping signal to the two electromechanical circuit breakers 355 and 365 which are arranged in the two lines 352 and 362 connected to the DC input 31. These two circuit breakers interrupt without any delay the reverse current I_{RA2} and I_{RA3} and a reverse current fed from the inverter or from additional parallel arranged array combiner boxes and at the same time disconnect the DC input 31 resp. the faulty cable C1 from the two busbars 35, 36. The remaining four circuit breakers 355 and 365 remain closed such that the arrays 2 and 3 feed the inverter via the array combiner box ACB again with DC current.

In the embodiment according to fig.6 the switching units 355 and 365 are realized as hybrid breakers and the two switching units 358 and 368 as electromechanical switches. In this embodiment the array combiner box ACB comprises an array combiner control unit ACCU which is shown in fig.7. The array combiner control unit ACCU communicates with switching units 355, 358, 365 and 368 and with the DC direction sensors 356, 366. The array combiner control unit ACCU receives output signals from the DC direction sensors 356, 366 and is enabled to generate tripping signals for opening or closing the switching units 355 and 365 in function of the outputs of the sensors 356 and 366.

As soon as the fault occurs in cable C1 the two DC direction detectors 356 and 366 guarding the DC input 31 detect the reverse current I_{RA2} and I_{RA3} and send a signal to the array combiner control unit ACCU. The array combiner control unit ACCU generates a tripping signal for opening the four switching units 355 and 365 which are connected via the DC inputs 32 and 33 to the arrays A2 and A3 and to the two switching units 358, 368. This tripping signal corresponds to the tripping signal T in case of the afore-discussed string combiner control unit SCB1 and is not sent to the two switching units 355 and 365 protecting the DC input 31.

The array combiner control unit ACCU communicates the afore-described tripping signal to the switching units 355, 365 protecting the DC inputs 32 and 33 and the switching units 358, 368 with a time delay with respect to the detection of the reverse current I_{A2}, I_{A3} when the reverse current still continues after the time delay. The time delay is at least the time required for disconnecting the faulty string S3 and a string combiner box SCB1 of the faulty array A1.

When the reverse current I_{RA2}, I_{RA3} disappears within this time delay, the tripping signal is not executed. Otherwise a reverse current I_{RA} is fed, typically from another array combiner box. The array combiner control unit ACCU then determines and indicates a fault in the cable C1. The tripping signal then causes the opening of the four switching units 355, 365, protecting the DC inputs 32, 33, and of the two switching units 358, 368.

After the interruption of the reverse current I_{RA} the two switching units 355, 365 protecting the DC input 31 are opened. After a fixed time delay (or upon a signal that the disconnect of these two switching units 355, 365 from the DC input 31 resp. from the faulty cable C1 was successful), the four switching units 355 and 365 protecting the DC inputs 32 and 33 and the switching units 358 and 368 close again and the PV plant is operational.

The switching units 355 and 365 protecting the cables C1, C2, C3 and the arrays A1, A2, A3 are coordinated in such a way, that they interrupt the DC current between the DC inputs 32 and 33 and the busbars 35 and 36 firstly. Thus the faultless arrays A2, A3 and the faultless cables C2, C3 no more feed any direct current into the fault. In case of an embodiment of the DC part of the photovoltaic plant, in which no further array combiner boxes are provided, the faulty cable C1 can be disconnected without current after a given time delay which depends on the time needed to discharge the filter capacitors of the inverter, typically 5 ms. Thus the switching units 355 and 365 only have to break or have to make a current circuit charged with a DC current in the order of the nominal current of just one of the arrays A1, A2 or A3. Thus these switching units can be small-sized.

The detection of the direction of the direct currents generated in the three arrays A1 to A3 allows a fast localization and removal of a faulty one of the cables C1 to C3 without any remarkable interruption of the PV device and with comparatively small-sized switching units 355 and 365. Thus the redundancy and the economy of the DC part of the PV plant according to the invention are improved additionally.

In a DC part of the photovoltaic plant which is kept on ground potential each string combiner box SCB1, SCB2,.. simply comprises m DC direction sensors. Furthermore, the DC part besides the DC direction sensors and the potential-to-ground sensors can comprise at least one of an under-voltage detector, an overcurrent detector and an overvoltage-protector.

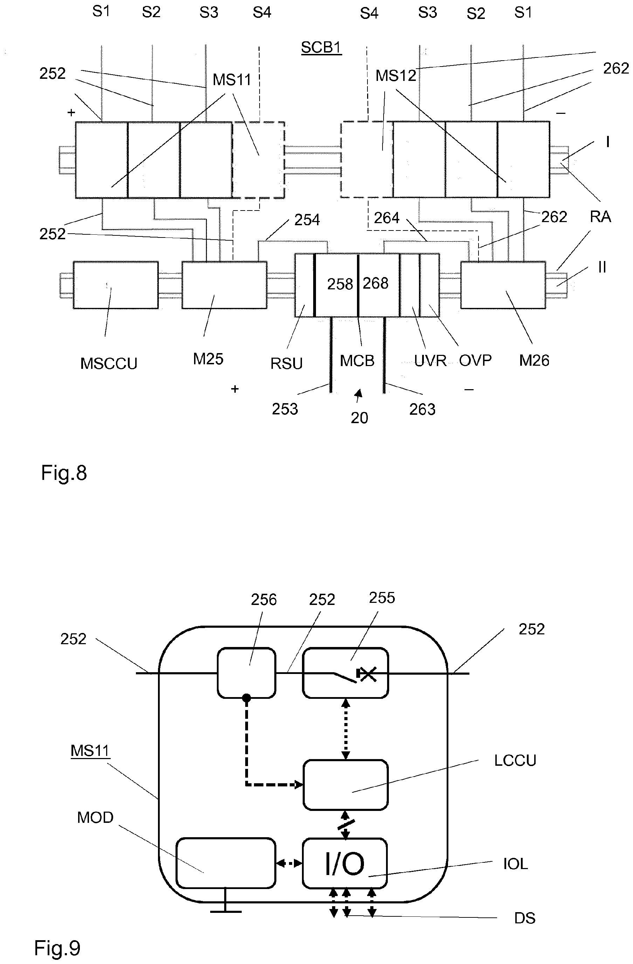

The mechanical layout of the circuit diagram of the string combiner box SCB1 according to fig.1 is shown in fig.8 and comprises a rail arrangement RA with two DIN rails I and II and a plurality of box-shaped modules attached to the rail arrangement RA. The mechanical layout may comprise instead of two rails only one rail but also three or more rails. The mechanical layout of the circuit diagram of the array combiner box ACB is similar.

In fig. 8 are shown two groups of four modules MS11 resp. MS12 which are attached to DIN rail I - i.e. the DIN rail number one. The term MS11 denotes a hybrid breaker module whereas MS12 denotes another hybrid breaker module or a disconnector module depending on the embodiment of the circuitry and the requirements. A first section of each of the four power 252 resp. return line connections 262 connects the power 251 resp. return line terminal 261 of the four DC inputs 21, ..., 24 (not shown in fig.8) to an input terminal (not referenced with a sign) of the module MS11 resp. MS12 and thus connects the module MS11 resp. MS12 to the power 11 resp. the return line 12 (not shown in fig.8) of one of the strings S1,.....,S4.

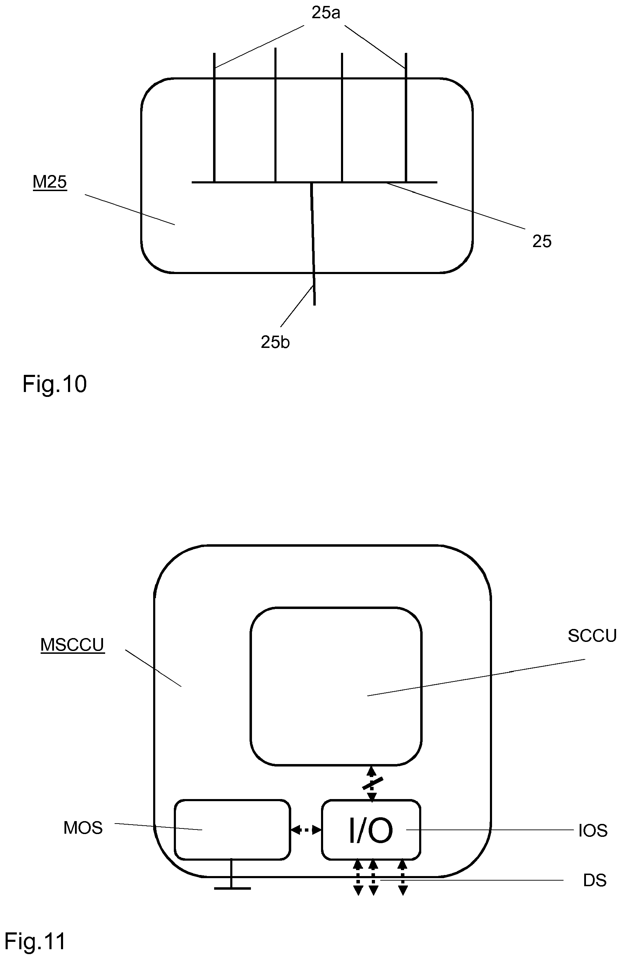

On DIN rail II (i.e. the DIN rail number two) there are arranged a module MSCCU, a module M25, a module MCB and a module M26. The term MCB denotes a breaker module suitable for breaking a current. The term MSCCU denotes a contained logic entity which will be dealt with in more detail in the description relating to figure 11. A second section of each of the four power line connections 252 connects an output terminal of the four modules MS11 electrically to one of four input terminals of the module M25 respectively, whereas a second section of each of the four return line connections 262 connects an output terminal of the four modules MS12 electrically to one of four input terminals of the module M26 respectively. The terms M25 and M26 denote busbar modules. A first section of the power line connection 254 connects an output terminal of the module M25 to one of two input terminals of the module MCB, whereas a first section of the return line connection 264 connects an output terminal of the module M26 to the other of the two input terminals of the module MCB.

Layouts of most of the modules are shown in figures 9 to 11. Not shown in these figures 9 to 11 is the module MCB. As can be taken from fig.8 this MCB module comprises the pair of the second switching units 258, 268 and is realized as a multi-pole rail mountable circuit breaker having at least two circuit breaker poles. This MCB module further comprises a remote switch unit RSU, an undervoltage release unit UVR and an overvoltage protection unit OVP. Both second switching units 258, 268 are controlled by the remote switch unit RSU. The term 'pole' is understood hereinafter as a single insulation gap that is delimited by two breaker terminals. Thus a multi-pole breaker is understood as a breaker having more than a single insulation gap.

In a basic, first embodiment of the MCB module the second switching units 258 and 268 are single-pole breakers each. Thus the second switching units 258 forms the first pole comprising a first breaker terminal and a second breaker terminal whereas the other second switching unit 268 forms the second pole comprising a third breaker terminal and a fourth breaker terminal. The first breaker terminal is connected to a section of the power line connection 253 at the DC output 20 whereas the second breaker terminal is connected to an end of a first section of the power line connection 254 a coming from module M25. Analogously the third breaker terminal is connected to a section of the power line connection 263 at the DC output 20 whereas the second breaker terminal is connected to an end of a first section of the power line connection 264 a coming from module M26.

In an second embodiment of the MCB module the second switching units 258 and 268 are double-pole breakers each. Thus the second switching units 258 forms the first pole comprising a first breaker terminal and a second breaker terminal as well as a second pole comprising a third breaker terminal and a fourth breaker terminal. The other second switching unit 268 forms the third pole comprising a fifth breaker terminal and a sixth breaker terminal as well as a fourth pole comprising a seventh breaker terminal and an eighth breaker terminal. This time a serial connection of first and second pole as well as third and fourth pole is established in that
- the first breaker terminal is connected to a section of the power line connection 253 at the DC output 20,
- the second breaker terminal is connected to the fourth breaker terminal,
- the third breaker terminal is connected to an end of a first section of the power line connection 254 a coming from module M25,
- the seventh breaker terminal is connected to a section of the power line connection 263 at the DC output 20,
- the sixth breaker terminal is connected to the eighth breaker terminal,
- the fifth breaker terminal is connected to an end of a first section of the power line connection 264 a coming from module M26

It goes without saying that such an embodiment is only useful if the electric connection at the first and second pole as well as at the third and fourth pole are broken simultaneously such that one pole needs to have only half of the dielectric strength compared to the basic embodiment explained above.

If the dielectric strength needs to be increased at each breaker pole any further the MCB module may comprise additional second switching modules on top of the two second switching modules 258, 268.

Depending on the embodiment of the second switching modules may be contained in a single switching device.

Fig.9 shows one of the modules MS11 and MS12 which are largely identical and which only distinguish from each other in terminals for electrically connecting the module MS11 to the power line 11 and the module MS12 to the return line 12 of the DC part of the photovoltaic plant. The shown module MS11 comprises a single switching unit 255 of the n pairs of identical switching units 255 and 265 typically executed as hybrid breaker, the first section of the power line connection 252 passing the input and the second section of the power line connection 252 passing an output of the module and a single DC direction sensor 256 of the eight identical DC direction sensors 256 and 266. The sensor 256 is arranged in the first section of the power line connection 252. The module further comprises a local control unit LCCU for receiving data signals from inside, in particular the DC direction sensor 256 and a manual operation switch MOD, and from outside, in particular the string combiner control unit SCCU, and for emitting data signals to the switching unit 255 and to the string combiner control unit SCCU. A data interface IOL communicates the data signals DS emitted from the local control unit LCCU to the string combiner control unit SCCU and from the string combiner control unit SCCU to the local control unit LCCU.

In the embodiment of the string combiner box SCB1 in which the switching units 255 are realized as hybrid breakers and the switching units 265 as disconnectors the modules M11 differ from the modules M12 additionally in the different designs of the switching units 255 and 265 and in the different layouts of the corresponding local control units LCCU.

Though not shown in fig.9 the module MS11 further comprises a potential-to-ground sensor of the n pairs of potential-to-ground sensors 257 and 267 or further sensors, like current sensors, needed to operated special designs of the DC part of the photovoltaic plant. The manual operation switch MOD enables the input of manually generated signals and the display of manually requested data signals DS. The local control units LCCU, like the string combiner control unit SCCU and the array combiner control unit ACCU, typically are realized as microprocessor.

The local control unit LCCU receives the output signal of the DC direction sensor 256 and emits the received signal to the string combiner control unit SCCU. The unit LCCU further emits a signal identifying the associated switching unit, here the switching unit 255, and its status. The local control unit LCCU receives the tripping signals, for instance the tripping signal T, and communicate it to the associated switching unit 255. When the switching unit 255 is realized as a hybrid breaker as shown in fig.4 the local control unit LCCU controls a current breaking process of the hybrid breaker as before-described in connection with the hybrid breaker according to fig.4. In the embodiments of the PV plant as shown in figures 5 to 7 the hydrid breaker 255 comprises an additional mechanical disconnector 255d connected in series with the mechanical contacts 255a as shown with dashed lines in fig.4.

Fig.10 shows one of the modules M25 and M26; These modules are identical in design. The shown module M25 comprises the power line busbar 25, four terminals 25a for receiving ends of the power line connections 252 of the DC inputs 21,..., 24 and a terminal 25b for receiving an end of the power line connection 254.

Fig.11 shows the module MSCCU. This module comprises the string combiner control unit SCCU, a manual operation switch MOS and a data interface IOS for communicating the data signals DS emitted from the string combiner control unit SCCU and the manual operation switch MOS to data receivers, like the local control units LCCU and the switching units 255, 265 of the modules MS11 and MS12 and the switching units 258 and 268 of the module MCB. The data interface IOS further communicates the data signals DS between the modules MS11, MS12 and MCB resp. the control units LCCU, the switching units 255, 265, the switching units 258, 268 and the manual operation switches MOD on the one side and the string combiner control unit SCCU on the other side. The manual operation switch MOS like the manual operation switch MOD enables the input of manually generated data signals and the display of manually requested data signals DS.

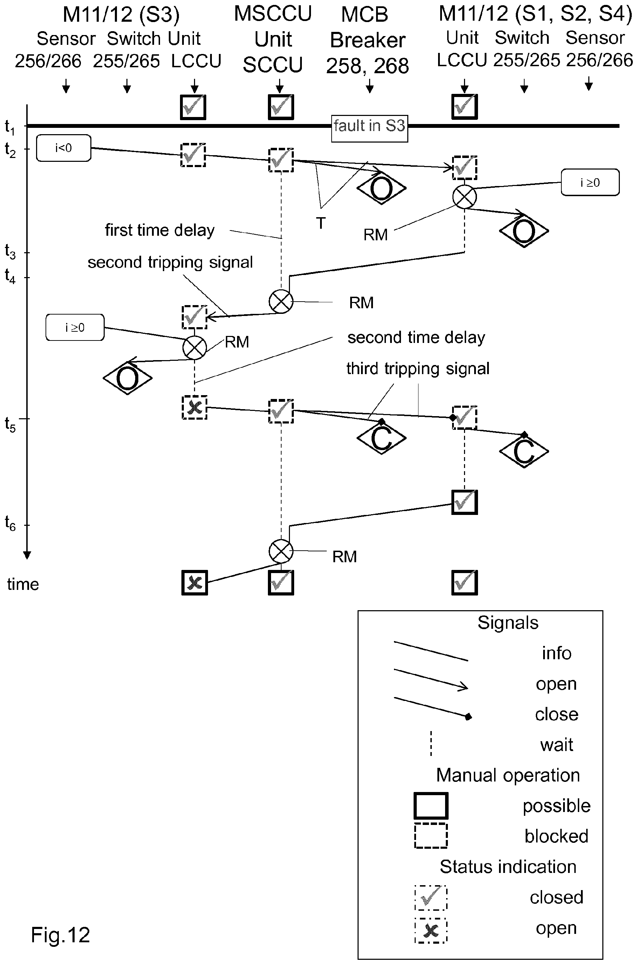

Fig. 12 illustrates the communication in the string combiner box shown in figures 1 and 2 and configured as shown in figures 8 to 11 during the interruption of a fault current in the faulty string 3. In fig.12 are shown the modules M11, M12 associated to the DC input 23 and thus to the faulty string 3, MSCCU, MCB and M11, M12 associated to the DC inputs 21, 22, 34 and thus to the strings S1, S2, S4 of the string combiner box SCB1 from left to right as follows;

The modules M11 and M12 associated to faulty string 3 comprising the DC direction sensor 256 or 266, the switching unit 255 or 265 and the local control unit LCCU.

The module MSCCU comprising the string combiner control unit SCCU.

The module MCB comprising the switching units 258 and 268.

The modules M11 and M12 associated to the strings S1, S2 and S4 comprising: the local control unit LCCU, the switching unit 255 or 265 and the DC direction sensor 256 or 266.

Each of the local control units LCCU and the string combiner control unit SCCU comprise a release member RM for the delay and/or release of the first tripping signal T and further data signals, like the second or third tripping signal or a confirmation signal.

The times tᵢ, i= 1, 2, ..., 6, are the action times shown in fig.3.

The sequence is as follows:
▪ Sequence
   ▪ Fault in string S3
   ▪ Current detector 256 of the module M11 (S3) detects reverse current and sends signal to the local control unit LCCU of M11 (S3)
   ▪ Current detector 266 of module M12 (S3) detects reverse current and sends signal to local control unit LCCU of M12 (S3)
   ▪ LCCU of M11 (S3) resp. of M12 (S3) sends signal to string combiner control SCCU,
   ▪ LCCU of M11 (S3) resp. M12 (S3) sends signal to the manual operating switch MOD in order to cause a status change and to block manual operation (not shown).
   ▪ String combiner control unit SCCU:
      ▪ SCCU sends the first tripping signal T to LCCUs of the modules M11 (S1, S2, S4) and M12 (S1, S2, S4).
      ▪ SCCU sends the first tripping signal to the remote switch unit RSU of the second switching units 258, 268
      ▪ SCCU waits for completion of switching operations
      ▪ SCCU sends signal to the manual operating switch MOS in order to cause a status change and to block manual operation (not shown).
   ▪ Local control units LCCU in modules M11 (S1, S2, S4), M12 (S1, S2, S4):
      ▪ The units LCCU check with their corresponding DC direction sensors 256, 266 that no reverse current is present
      ▪ The units LCCU send the first tripping signal T to their associated switching units (255, 265)
      ▪ The units LCCU send signals to their manual operating switches MOS in order to cause a status change and to block manual operation (not shown).
   ▪ Switching units 255, 265 of M11(S1, S2, S4), M12 (S1, S2, S4) interrupt the current in forward direction
   ▪ LCCUs in M11, M12 (S1, S2, S4):
      ▪ Wait for upon completion of switching (pre-determined time)
      ▪ Send confirmation signal to SCCU
   ▪ SCCU:
      ▪ Receives confirmation signals of LCCUs
      ▪ Continues waiting for the end of slower switching operation of breakers 258,268 (pre-determined first time delay time)
      ▪ Sends the first tripping signal T with the first time delay to the LCCUs of M11, M12 (S3) when member RM has released the output of SCCU
   ▪ LCCUs of M11, M12 (S3):
      ▪ Check with their corresponding sensors 256, 266 that no reverse current is present
      ▪ Send the first tripping signal T to their corresponding switching units 255, 265
      ▪ Wait for upon completion of switching (pre-determined time)
      ▪ Send confirmation signal to SCCU
   ▪ SCCU:
      ▪ Receives confirmation signals of LCCUs of M11, M12 (S3)
      ▪ Sends the second tripping signal (closing) to LCCUs in M11, M12 (S1, S2, S4)
      ▪ Sends the second tripping signal to the remote switch unit RSU of the breakers 258,268
   ▪ LCCUs in M11, M12 (S1, S2, S4):
      ▪ Send closing signal to their associated switching units (255, 265)
      ▪ wait for upon completion of switching (pre-determined time)
      ▪ Send signals to their manual operation switches MOD in order to cause a status change and to unblock the manual operation
      ▪ Send confirmation signal to SCCU
   ▪ SCCU:
      ▪ Receives confirmation signal of LCCUs in M11, M12 (S1, S2, S3, S4)
      ▪ Waits for pre-determined time for switching operation of breakers 258, 268
      ▪ Sends request to unblock manual operation switches of LCCUs in M11, M12 (S3)
      ▪ Sends signals to manual operating switch MOS in order to indicate the status change and to unblock the manual operation switch MOS
   ▪ LCCUs in M11, M12 (S3):
      ▪ Send signals to unblock the manual operation switches MOD

### List of Reference Signs

- A1, A2, A3: arrays
- ACB: array combiner box
- ACCU: array combiner control unit
- C1, C2, C3: cables
- DS: data signals
- I, II: rails
- IOL, IOS: data interfaces
- I_{A1}: direct array current
- I_{RA2}, I_{RA3}: reverse array current
- I_{R}: reverse current
- I_{Ro}: reverse current
- I_{RA}: reverse current
- I_{S1}, I_{S2}, I_{S3}, I_{S4}: direct string currents
- K: component of the PV plant
- LCCU: local control unit
- MOD, MOS: manual operation switches
- MS11: hybrid breaker module
- MS12: hybrid breaker module / disconnector module
- MSCCU: contained logic entity comprising an SCCU
- M25, M26: busbar module
- MCB: breaker module
- OVP: overvoltage protection unit
- RA: rail arrangement
- RM: release member
- RSU: remote switch unit
- S1, S2, S3, S4: strings
- SCB1, SCB2, SCB3: string combiner boxes
- SCCU: string combiner control unit
- UVR: undervoltage release unit
- 10: PV modules
- 11: power line
- 12: return line
- 13: ground connection
- 20: DC output
- 21, 22, 23, 24: DC inputs
- 25: power line busbar
- 26: return line busbar
- 251, 253: power line terminals
- 252, 254: power line connections,
- 261, 263: return line terminals
- 262, 264: return line connections
- 255, 258, 265, 268: switching units
- 255a: mechanical contacts
- 255b: controllable semiconductor switch
- 255c: varistor
- 255d: disconnector
- 256, 266: DC direction sensors
- 257, 267: potential-to-ground sensors
- 30: DC output
- 31, 32, 33: DC inputs
- 35: power line busbar
- 36: return line busbar
- 351, 353: power line terminals
- 352, 354: power line connections,
- 361, 363: return line terminals
- 362,364: return line connections
- 355, 358, 365, 368: switching units
- 356, 366: DC direction sensors

## Claims

1. A combiner box (SCB1, SCB2, SCB3) for combining n strings (S1, S2, S3, S4) of a DC part of a PV plant, wherein n are integers greater 2,
the combiner box comprising:
- a plurality of n DC inputs (21, 22, 23, 24) for electrical connection to the n strings,
- a DC output (20) for electrical connection to at least one of an inverter (K) or an array combiner box (ACB) of the DC part,
- a power line busbar (25) which is electrically connected to power line terminals (251) of the n DC inputs by means of n first power line connections (252;) and to a power line terminal (253) of the DC output (20) by means of a second power line connection (254),
- a return line busbar (26; 36) which is electrically connected to return line terminals (261; 361) of the n DC inputs by means of n first return line connections (262) and to a return line terminal (263) of the DC output (20) by means of a second return line connection (264),
- a plurality of n pairs of first switching units (255, 265), one member (255) of each pair being arranged in one of the n first power line connections (252) and another member (265) of each pair in a corresponding one of the n first return line connections (262),
- a plurality of at least n DC direction sensors (256, 266) for detecting the direction of direct currents (I_{S1},.., I_{S4}) conducted in the n first power line connections (252) or in the n first return line connections (262), wherein each sensor is associated to at least one member of a pair of the first switching units, and
- a combiner control unit (SCCU) for tripping the first switching units,
in which the DC direction sensors communicate their output signals to the combiner control unit (SCCU),
**characterized in**
**that** the combiner box comprises a pair of second switching units (258, 268), one member (258) of which being arranged in the second power line connection (254) and another member (268) of which being arranged in the second return line connection (264), and
in that the combiner control unit (SCCU) is configured
to communicate a first tripping signal (T) to the first switching units for opening n-1 of the n pairs of first switching units in order to interrupt the direct currents (I_{S1}, I_{S2}, I_{S4}) between each of n-1 DC inputs (21, 22, 24) and the two busbars (25, 26) when in a remaining one (23) of the DC inputs the direct current changes from a forward (I_{S3}) to a first reverse current (I_{R}), and
to communicate the first tripping signal (T) without any time delay to the pair of second switching units (258, 268) in order to open these second switching units and to break a second reverse current (I_{Ro}) fed through the DC output (20), and
**that** the combiner control unit (SCCU) is configured to communicate a second tripping signal for opening the pair of first switching units (255, 265) associated to the remaining DC input (23) with a first time delay, wherein the first time delay is at least the time required for breaking the second reverse current (I_{Ro}) or wherein the first time delay is configured to match the discharge of the filter capacitors of the inverter (K).

2. A combiner box (ACB) for combining m arrays (A1, A2, A3) of a DC part of a PV plant, wherein m are integers greater 2,
the combiner box comprising:
- a plurality of m DC inputs (31, 32, 33) for electrical connection to the m arrays,
- a DC output (30) for electrical connection to an inverter (K) of the DC part,
- a power line busbar (35) which is electrically connected to power line terminals (351) of the m DC inputs by means of m first power line connections (352) and to a power line terminal (353) of the DC output (30) by means of a second power line connection (354),
- a return line busbar (36) which is electrically connected to return line terminals (361) of the m DC inputs by means of m first return line connections (362) and to a return line terminal (363) of the DC output (30) by means of a second return line connection (364),
- a plurality of m pairs of first switching units (355, 365), one member (355) of each pair being arranged in one of the m first power line connections (352) and another member (365) of each pair in a corresponding one of the m first return line connections (362),
- a plurality of at least m DC direction sensors (356, 366) for detecting the direction of direct currents (I_{A1},.., I_{A3}) conducted in the m first power line connections (352) or in the m first return line connections (362), wherein each sensor is associated to at least one member of a pair of the first switching units, and
- a combiner control unit (ACCU) for tripping the first switching units,
in which the DC direction sensors communicate their output signals to the combiner control unit (ACCU),
**characterized in**
**that** the combiner box comprises the array combiner control unit (ACCU), and in that the array combiner box (ACB) comprises a pair of second switching units (358, 368), one member (358) of which being arranged in the second power line connection (354) and another member (368) of which being arranged in the second return line connection (364),
and wherein the array combiner box (ACB) further comprises the m pairs of first switching units (355, 365) and the pair of second switching units (358, 368),
wherein the array combiner control unit (ACCU) is configured to communicate a first tripping signal (T) to the first switching units (355, 365) for opening m-1 of the m pairs of first switching units in order to interrupt the direct currents (I_{A2}, I_{A3}) between each of m-1 DC inputs (32, 33) and the two busbars (35, 36) when in a remaining one (31) of the DC inputs the direct current changes from a forward (I_{A1}) to a first reverse current (I_{RA2}, I_{RA3}), and wherein the array combiner control unit (ACCU) is configured to communicate the first tripping signal (T) to the m-1 pairs of first switching units (355, 365) and the pair of second switching units (358, 368) delayed in time with respect to the detection of the first reverse current (I_{A2}, I_{A3}) in order to open these second switching units and to break a second reverse current (I_{RA}) fed through the DC output (30), when the first reverse current is still present after the delay in time, and
wherein the delay in time is at least as long as the time required for disconnecting a faulty string (S3) and a string combiner box (SCB1) of a faulty array (A1) which by means of a cable (C1) is connectable to the remaining DC input (31) of the array combiner box (ACB), and
wherein the array combiner control unit (ACCU) is configured to communicate a second tripping signal for opening the pair of first switching units (355, 365) associated to the remaining DC input (31) with a first time delay, wherein the first time delay is at least the time required for breaking the second reverse current (I_{Ro}; I_{RA}) or where the first time delay is configured to match the discharge of the filter capacitors of the inverter (K).

3. The combiner box according to claim 1 or 2,
**characterized in**
**that** each member of the pair of second switching units (258, 268; 358, 368) is realized as an electromechanical circuit breaker or disconnector.

4. The combiner box according to any of any one of claims 1 to 3,
**characterized in**
**that** the combiner control unit is further configured to communicate a third tripping signal for closing the n-1 or m-1 pairs of first switching units and the pair of second switching units with a second time delay in order to reconnect the n-1 or m-1 DC inputs (21, 22, 24; 32, 33) and the DC output (20; 30) to the two busbars (25, 26; 35, 36), wherein the second time delay is at least the time required for opening the pair of first switching units associated to the remaining DC input (23; 31).

5. The combiner box according to any of claims 1 to 4,
**characterized in**
**that** the combiner box comprises a plurality of n or m pairs of DC direction sensors, wherein each sensor is associated to one of the first switching units.

6. The combiner box according to one of claims 1 to 5,
**characterized in**
**that** at least one member of each of the n or m pairs of first switching units (255, 265; 355, 365) is realized as a hybrid breaker.

7. The combiner box according to claim 6,
**characterized in**
**that** at least one other member of each of the n or m pairs of first switching units (255, 265; 355, 365) is realized as an electromechanical disconnector.

8. The combiner box according to any of claims 1 to 7,
**characterized in**
**that** the combiner box further comprises n or m pairs of local control units (LCCU), wherein each local unit is associated to one of the first switching units (255, 265; 355, 365),
**that** each DC direction sensor (256, 266; 356, 366) communicates its output signals to at least one associated member of a pair of the n or m pairs of local control units,
**that** at least one associated member of a pair of the n or m pairs of local control units communicates the output signals of the associated DC direction sensor to the combiner control unit (SCCU; ACCU), and
**that** the local control unit (LCCU) communicates the first tripping signal (T) and any further data signal to the associated first switching unit.

9. The combiner box according to claim 8,
**characterized in**
**that** the combiner control unit (SCCU) and each of the local control units (LCCU) comprise a control member (RM) for the delay and release of the first tripping signal (T) and any further data signal.

10. The combiner box according to one of claims 8 or 9,
**characterized in**
**that** the combiner box comprises a rail arrangement (RA) and a plurality of box-shaped modules (MS11, MS12, MSCCU, M25, M26, MCB) attached to the rail arrangement (RA).

11. The combiner box according to claim 10,
**characterized in**
**that** a first module (MS11, MS12) of the plurality of modules comprises a single switching unit (255) of the n or m pairs of the first switching units,
a section of the power (252) or the return line connection passing the first module between an input and an output terminal,
a single DC direction sensor (256) of the at least n or m DC direction sensors,
a local control unit (LCCU) of the plurality of n or m pairs of local control units for receiving data signals from the single DC direction sensor (256) and the single switching unit (255) and for transmitting data signals to the single switching unit, and
a data interface (IOL) for communicating data signals (DS) between its logic control unit (LCCU) and the combiner control unit (SCCU).

12. The combiner box according to claim 1,
**characterized in**
**that** a potential-to-ground sensor (257, 267) is arranged in each of the n first power line connections (252) and the corresponding n return line connections (262).

13. The combiner box according to claim 12,
**characterized in**
**that** the potential-to-ground sensors (257, 267) are realized as voltage dividers.

14. A DC part of a PV plant comprising at least a combiner box according to any of claims 1 to 13.

15. The DC part according to claim 14, in which the at least a combiner box comprises at least first combiner box that is realized as string combiner box (SCB1, SCB2, SCB3) according to claim 1, and
a second combiner box that is realized as an array combiner box (ACB) according to claim 2 in which each of the m pairs of first switching units (355, 365) comprises two electromechanical circuit breakers,
wherein the second combiner box (ACB) is connected to the first combiner box (SCB1, SCB2, SCB3) via the DC output (31, 32, 33) of the first combiner box (SCB1, SCB2, SCB3).

## Patentansprüche

1. Eine Combinerbox (SCB1, SCB2, SCB3) zum Kombinieren von n Strängen (S1, S2, S3, S4) eines DC-Teils einer PV-Anlage, wobei n eine ganze Zahl größer als 2 ist, die Combinerbox umfassend:
- eine Vielzahl von n DC-Eingängen (21, 22, 23, 24) zur elektrischen Verbindung mit den n Strängen,
- einen DC-Ausgang (20) zur elektrischen Verbindung mit mindestens einem von einem Wechselrichter (K) oder einer Array-Combinerbox (ACB) des DC-Teils,
- eine Stromleitungssammelschiene (25), die elektrisch mit Stromleitungsanschlüssen (251) der n DC-Eingänge mittels n ersten Stromleitungsverbindungen (252) verbunden ist; und mit einem Stromleitungsanschluss (253) des DC-Ausgangs (20) mittels einer zweiten Stromleitungsverbindung (254),
- eine Rückleitungssammelschiene (26, 36), die elektrisch mit Rückleitungsanschlüssen (261, 361) der n DC-Eingänge mittels n ersten Rückleitungsverbindungen (262) und mit einem Rückleitungsanschluss (263) des DC-Ausgangs (20) mittels einer zweiten Rückleitungsverbindung (264) verbunden ist,
- eine Vielzahl von n Paaren von ersten Schalteinheiten (255, 265), wobei ein Element (255) jedes Paares in einer der n ersten Stromleitungsverbindungen (252) und ein anderes Element (265) jedes Paares in einer entsprechenden der n ersten Rückleitungsverbindungen (262) angeordnet ist,
- eine Vielzahl von mindestens n DC-Richtungssensoren (256, 266) zum Erkennen der Richtung von Gleichströmen (I_{S1},.., I_{S4}), die in den n ersten Stromleitungsverbindungen (252) oder in den n ersten Rückleitungsverbindungen (262) geleitet werden, wobei jeder Sensor mindestens einem Element eines Paares der ersten Schalteinheiten zugeordnet ist, und
- eine Combinersteuereinheit (SCCU) zum Auslösen der ersten Schalteinheiten, in denen die DC-Richtungssensoren ihre Ausgangssignale an die Combinersteuereinheit (SCCU) kommunizieren,
**dadurch gekennzeichnet,**
**dass** die Combinerbox ein Paar von zweiten Schalteinheiten (258, 268) umfasst, von denen ein Element (258) in der zweiten Stromleitungsverbindung (254) angeordnet ist und von denen ein anderes Element (268) in der zweiten Rückleitungsverbindung (264) angeordnet ist, und
**dass** die Combinersteuereinheit (SCCU) konfiguriert ist, um ein erstes Auslösesignal (T) an die ersten Schalteinheiten zum Öffnen von n-1 der n Paare von ersten Schalteinheiten zu kommunizieren, um die Gleichströme (I_{S1}, I_{S2}, I_{S4}) zwischen jedem der n-1 DC-Eingänge (21, 22, 24) und den beiden Sammelschienen (25, 26) zu unterbrechen, wenn in einem verbleibenden (23) der DC-Eingänge der Gleichstrom von einem Vorwärts- (I_{S3}) zu einem ersten Rückwärtsstrom (I_{R}) wechselt, und das erste Auslösesignal (T) ohne Zeitverzögerung an das Paar von zweiten Schalteinheiten (258, 268) zu kommunizieren, um diese zweiten Schalteinheiten zu öffnen und einen zweiten durch den DC-Ausgang (20) geleiteten Rückwärtsstrom (I_{Ro}) zu unterbrechen, und
**dass** die Combinersteuereinheit (SCCU) konfiguriert ist, um ein zweites Auslösesignal zum Öffnen des dem verbleibenden DC-Eingang (23) mit einer ersten Zeitverzögerung zugeordneten Paares von ersten Schalteinheiten (255, 265) mit einer ersten Zeitverzögerung zu kommunizieren, wobei die erste Zeitverzögerung mindestens die Zeit ist, die zum Unterbrechen des zweiten Rückwärtsstroms (I_{Ro}) benötigt wird, oder wobei die erste Zeitverzögerung konfiguriert ist, um die Entladung der Filterkondensatoren des Wechselrichters (K) anzugleichen.

2. Eine Combinerbox (ACB) zum Kombinieren von m Arrays (A1, A2, A3) eines DC-Teils einer PV-Anlage, wobei m eine ganze Zahl größer als 2 ist,
die Combinerbox umfassend:
- eine Vielzahl von m DC-Eingängen (31, 32, 33) zur elektrischen Verbindung mit den m Arrays,
- einen DC-Ausgang (30) zur elektrischen Verbindung mit einem Wechselrichter (K) des DC-Teils,
- eine Stromleitungssammelschiene (35), die elektrisch mit Stromleitungsanschlüssen (351) der m DC-Eingänge mittels m erster Stromleitungsverbindungen (352) und mit einem Stromleitungsanschluss (353) des DC-Ausgangs (30) mittels einer zweiten Stromleitungsverbindung (354) verbunden ist,
- eine Rückleitungssammelschiene (36), die elektrisch mit Rückleitungsanschlüssen (361) der m DC-Eingänge mittels m ersten Rückleitungsverbindungen (362) und mit einem Rückleitungsanschluss (363) des DC-Ausgangs (30) mittels einer zweiten Rückleitungsverbindung (364) verbunden ist,
- eine Vielzahl von m Paaren von ersten Schalteinheiten (355, 365), wobei ein Element (355) jedes Paares in einer der m ersten Stromleitungsverbindungen (352) und ein anderes Element (365) jedes Paares in einer entsprechenden der m ersten Rückleitungsverbindungen (362) angeordnet ist,
- eine Vielzahl von mindestens m DC-Richtungssensoren (356, 366) zum Erkennen der Richtung von Gleichströmen (I_{A1},.., I_{A3}), die in den m ersten Stromleitungsverbindungen (352) oder in den m ersten Rückleitungsverbindungen (362) geleitet werden, wobei jeder Sensor mindestens einem Element eines Paares der ersten Schalteinheiten zugeordnet ist, und
- eine Combinersteuereinheit (ACCU) zum Auslösen der ersten Schalteinheiten, wobei die DC-Richtungssensoren ihre Ausgangssignale an die Combinersteuereinheit (ACCU) kommunizieren,
**dadurch gekennzeichnet,**
**dass** die Combinerbox die Array-Combinersteuereinheit (ACCU) umfasst und dass die Array-Combinerbox (ACB) ein Paar von zweiten Schalteinheiten (358, 368) umfasst, von denen ein Element (358) in der zweiten Stromleitungsverbindung (354) und von denen ein anderes Element (368) in der zweiten Rückleitungsverbindung (364) angeordnet ist,
und wobei die Array-Combinerbox (ACB) ferner die m Paare von ersten Schalteinheiten (355, 365) und das Paar von zweiten Schalteinheiten (358, 368) umfasst,
wobei die Array-Combinersteuereinheit (ACCU) konfiguriert ist, um ein erstes Auslösesignal (T) an die ersten Schalteinheiten (355, 365) zum Öffnen von m-1 der m Paare von ersten Schalteinheiten zu kommunizieren, um die Gleichströme (I_{A2}, I_{A3}) zwischen jedem der m-1 DC-Eingänge (32, 33) und den zwei Sammelschienen (35, 36) zu unterbrechen, wenn in einem verbleibenden (31) der DC-Eingänge der Gleichstrom von einem Vorwärts- (I_{A1}) zu einem ersten Rückwärtsstrom (I_{RA2}, I_{RA3}) wechselt, und wobei die Array-Combinersteuereinheit (ACCU) konfiguriert ist, um das erste Auslösesignal (T) an die m-1 Paare von ersten Schalteinheiten (355, 365) und das Paar von zweiten Schalteinheiten (358, 368) mit Zeitverzögerung in Bezug auf die Erkennung des ersten Rückwärtsstroms (I_{A2}, I_{A3}) zu kommunizieren, um diese zweiten Schalteinheiten zu öffnen und einen zweiten Rückwärtsstrom (I_{RA}) zu unterbrechen, der durch den DC-Ausgang (30) geleitet wird, wenn der erste Rückwärtsstrom nach der Zeitverzögerung immer noch vorhanden ist, und
wobei die Zeitverzögerung mindestens so lang ist wie die Zeit, die zum Trennen eines fehlerhaften Strangs (S3) und einer Strang-Combinerbox (SCB1) eines fehlerhaften Arrays (A1) benötigt wird, das mittels eines Kabels (C1) mit dem verbleibenden DC-Eingang (31) der Array-Combinerbox (ACB) verbindbar ist, und
wobei die Array-Combinersteuereinheit (ACCU) konfiguriert ist, um ein zweites Auslösesignal zum Öffnen des dem verbleibenden DC-Eingang (31) mit einer ersten Zeitverzögerung zugeordneten Paares von ersten Schalteinheiten (355, 365) zu kommunizieren, wobei die erste Zeitverzögerung mindestens die Zeit ist, die zum Unterbrechen des zweiten Rückwärtsstroms (I_{Ro}, I_{RA}) benötigt wird, oder wobei die erste Zeitverzögerung konfiguriert ist, um die Entladung der Filterkondensatoren des Wechselrichters (K) anzugleichen.

3. Die Combinerbox nach Anspruch 1 oder 2,
**dadurch gekennzeichnet,**
**dass** jedes Element des Paares von zweiten Schalteinheiten (258, 268, 358, 368) als ein elektromechanischer Leistungsschalter oder Trennschalter realisiert ist.

4. Die Combinerbox nach jedem der Ansprüche 1 bis 3,
**dadurch gekennzeichnet,**
**dass** die Combinersteuereinheit ferner konfiguriert ist, um ein drittes Auslösesignal zum Schließen der n-1 oder m-1 Paare von ersten Schalteinheiten und des Paares von zweiten Schalteinheiten mit einer zweiten Zeitverzögerung zu kommunizieren, um die n-1 oder m-1 DC-Eingänge (21, 22, 24, 32, 33) und den DC-Ausgang (20, 30) erneut mit den zwei Sammelschienen (25, 26, 35, 36) zu verbinden, wobei die zweite Zeitverzögerung mindestens die Zeit ist, die zum Öffnen des dem verbleibenden DC-Eingang (23, 31) zugeordneten Paares von ersten Schalteinheiten benötigt wird.

5. Die Combinerbox nach jedem der Ansprüche 1 bis 4,
**dadurch gekennzeichnet,**
**dass** die Combinerbox eine Vielzahl von n oder m Paaren von DC-Richtungssensoren umfasst, wobei jeder Sensor einer der ersten Schalteinheiten zugeordnet ist.

6. Die Combinerbox nach einem der Ansprüche 1 bis 5,
**dadurch gekennzeichnet,**
**dass** mindestens ein Element von jedem der n oder m Paare von ersten Schalteinheiten (255, 265, 355, 365) als ein Hybridunterbrecher realisiert ist.

7. Die Combinerbox nach Anspruch 6,
**dadurch gekennzeichnet,**
**dass** mindestens ein Element von jedem der n oder m Paare von ersten Schalteinheiten (255, 265, 355, 365) als ein elektromechanischer Trennschalter realisiert ist.

8. Die Combinerbox nach jedem der Ansprüche 1 bis 7,
**dadurch gekennzeichnet,**
**dass** die Combinerbox ferner n oder m Paare von lokalen Steuereinheiten (LCCU) umfasst, wobei jede lokale Einheit einer der ersten Schalteinheiten (255, 265, 355, 365) zugeordnet ist,
**dass** jeder DC-Richtungssensor (256, 266, 356, 366) seine Ausgangssignale an mindestens ein zugeordnetes Element eines Paares von den n oder m Paaren von lokalen Steuereinheiten kommuniziert,
**dass** mindestens ein zugeordnetes Element eines Paares von den n oder m Paaren von lokalen Steuereinheiten die Ausgangssignale des zugeordneten DC-Richtungssensors an die Combinersteuereinheit (SCCU, ACCU) kommuniziert, und
**dass** die lokale Steuereinheit (LCCU) das erste Auslösesignal (T) und jedes weitere Datensignal an die zugeordnete erste Schalteinheit kommuniziert.

9. Die Combinerbox nach Anspruch 8,
**dadurch gekennzeichnet,**
**dass** die Combinersteuereinheit (SCCU) und jede der lokalen Steuereinheiten (LCCU) ein Steuerelement (RM) für die Verzögerung und Abgabe des ersten Auslösesignals (T) und jedes weiteren Datensignals umfassen.

10. Die Combinerbox nach einem der Ansprüche 8 oder 9,
**dadurch gekennzeichnet,**
**dass** die Combinerbox eine Schienenanordnung (RA) und mehrere an der Schienenanordnung (RA) befestigte kastenförmige Module (MS11, MS12, MSCCU, M25, M26, MCB) umfasst.

11. Die Combinerbox nach Anspruch 10,
**dadurch gekennzeichnet,**
**dass** ein erstes Modul (MS11, MS12) der Vielzahl von Modulen eine einzelne Schalteinheit (255) von den n oder m Paaren der ersten Schalteinheiten,
einen Abschnitt der Strom- (252) oder die Rückleitungsverbindung, die das erste Modul zwischen einem Eingangs- und einem Ausgangsanschluss durchquert,
einen einzelnen DC-Richtungssensor (256) der mindestens n oder m DC-Richtungssensoren,
eine lokale Steuereinheit (LCCU) der Vielzahl von n oder m Paaren von lokalen Steuereinheiten zum Empfangen von Datensignalen von dem einzelnen DC-Richtungssensor (256) und der einzelnen Schalteinheit (255) und zum Übertragen von Datensignalen an die einzelne Schalteinheit, und
eine Datenschnittstelle (IOL) zum Kommunizieren von Datensignalen (DS) zwischen ihrer Logiksteuereinheit (LCCU) und der Combinersteuereinheit (SCCU) umfasst.

12. Die Combinerbox nach Anspruch 1,
**dadurch gekennzeichnet,**
**dass** ein Potential-zu-Erde-Sensor (257, 267) in jeder der n ersten Stromleitungsverbindungen (252) und den entsprechenden n Rückleitungsverbindungen (262) angeordnet ist.

13. Die Combinerbox nach Anspruch 12,
**dadurch gekennzeichnet,**
**dass** die Potential-zu-Erde-Sensoren (257, 267) als Spannungsteiler realisiert sind.

14. Ein DC-Teil einer PV-Anlage, umfassend mindestens eine Combinerbox nach einem der Ansprüche 1 bis 13.

15. Das DC-Teil nach Anspruch 14, bei dem die mindestens eine Combinerbox mindestens eine erste Combinerbox aufweist, die als Strang-Combinerbox (SCB1, SCB2, SCB3) gemäß Anspruch 1 realisiert ist, und
eine zweite Combinerbox, die als eine Array-Combinerbox (ACB) gemäß Anspruch 2 realisiert ist, bei der jedes der m Paare von ersten Schalteinheiten (355, 365) zwei elektromechanische Leistungsschalter umfasst,
wobei die zweite Combinerbox (ACB) über den DC-Ausgang (31, 32, 33) der ersten Combinerbox (SCB1, SCB2, SCB3) mit der ersten Combinerbox (SCB1, SCB2, SCB3) verbunden ist.

## Revendications

1. Boîtier de combinaison (SCB1, SCB2, SCB3) pour combiner n chaînes (S1, S2, S3, S4) d'une partie de courant continu (CC) d'une installation photovoltaïque, où n sont des entiers supérieurs à 2, le boîtier de combinaison comprenant :
- une pluralité de n entrées CC (21, 22, 23, 24) pour la connexion électrique aux n chaînes,
- une sortie CC (20) pour une connexion électrique à au moins l'un d'un onduleur (K) ou d'un boîtier de combinaison de réseaux (ACB) de la partie CC,
- une barre omnibus de ligne d'alimentation (25) qui est connectée électriquement à des bornes de ligne d'alimentation (251) des n entrées CC au moyen de n premières connexions de ligne d'alimentation (252) et à une borne de ligne d'alimentation (253) de la sortie CC (20) au moyen d'une seconde connexion de ligne d'alimentation (254),
- une barre omnibus de ligne de retour (26 ; 36) qui est connectée électriquement à des bornes de ligne de retour (261 ; 361) des n entrées CC au moyen de n premières connexions de ligne de retour (262) et à une borne de ligne de retour (263) de la sortie CC (20) au moyen d'une seconde connexion de ligne de retour (264),
- une pluralité de n paires de premières unités de commutation (255, 265), un élément (255) de chaque paire étant agencé dans l'une des n premières connexions de ligne d'alimentation (252) et un autre élément (265) de chaque paire dans une connexion correspondante des n premières connexions de ligne de retour (262),
- une pluralité d'au moins n capteurs de direction CC (256, 266) pour détecter la direction de courants continus (Is1, ..., Is4) conduits dans les n premières connexions de ligne d'alimentation (252) ou dans les n premières connexions de ligne de retour (262), dans lequel chaque capteur est associé à au moins un élément d'une paire des premières unités de commutation, et
- une unité de commande de combineur (SCCU) pour déclencher les premières unités de commutation, dans lequel les capteurs de direction CC communiquent leurs signaux de sortie à l'unité de commande de combineur (SCCU),
**caractérisé en ce que**
le boîtier de combinaison comprend une paire de secondes unités de commutation (258, 268), dont un élément (258) est agencé dans la seconde connexion de ligne d'alimentation (254) et dont un autre élément (268) est agencé dans la seconde connexion de ligne de retour (264), et
**en ce que** l'unité de commande de combineur (SCCU) est configurée pour communiquer un premier signal de déclenchement (T) aux premières unités de commutation pour ouvrir n-1 des n paires de premières unités de commutation afin d'interrompre les courants continus (Is1, Is2, Is4) entre chacune des n-1 entrées CC (21, 22, 24) et les deux barres omnibus (25, 26) lorsque dans une entrée restante (23) des entrées CC, le courant continu passe d'un courant direct (Is3) à un premier courant inverse (IR), et communiquer le premier signal de déclenchement (T) sans aucun retard à la paire de secondes unités de commutation (258, 268) afin d'ouvrir ces secondes unités de commutation et de couper un second courant inverse (IR0) distribué par la sortie CC (20), et
**en ce que** l'unité de commande de combineur (SCCU) est configurée pour communiquer un second signal de déclenchement pour ouvrir la paire de premières unités de communication (255, 265) associées à l'entrée CC restante (23) avec un premier retard, dans lequel le premier retard est au moins le temps nécessaire pour couper le second courant inverse (IR0) ou dans lequel le premier retard est configuré pour correspondre à la décharge des condensateurs de filtrage de l'onduleur (K) .

2. Boîtier de combinaison (ACB) pour combiner m réseaux (A1, A2, A3) d'une partie CC d'une installation photovoltaïque, où m sont des entiers supérieurs à 2, le boîtier de combinaison comprenant :
- une pluralité de m entrées CC (31, 32, 33) pour la connexion électrique aux m réseaux,
- une sortie CC (30) pour la connexion électrique à un onduleur (K) de la partie CC,
- une barre omnibus de ligne d'alimentation (35) qui est connectée électriquement à des bornes de ligne d'alimentation (351) des m entrées CC au moyen de m premières connexions de ligne d'alimentation (352) et à une borne de ligne d'alimentation (353) de la sortie CC (30) au moyen d'une seconde connexion de ligne d'alimentation (354),
- une barre omnibus de ligne de retour (36) qui est connectée électriquement à des bornes de ligne de retour (361) des m entrées CC au moyen de m premières connexions de ligne de retour (362) et à une borne de ligne de retour (363) de la sortie CC (30) au moyen d'une seconde connexion de ligne de retour (364),
- une pluralité de m paires de premières unités de commutation (355, 365), un élément (355) de chaque paire étant agencé dans l'une des m premières connexions de ligne d'alimentation (352) et un autre élément (365) de chaque paire dans une connexion correspondante des m premières connexions de ligne de retour (362),
- une pluralité d'au moins m capteurs de direction CC (356, 366) pour détecter la direction de courants continus (IA1, ..., IA3) conduits dans les m premières connexions de ligne d'alimentation (352) ou dans les m premières connexions de ligne de retour (362), dans lequel chaque capteur est associé à au moins un élément d'une paire des premières unités de commutation, et
- une unité de commande de combineur (ACCU) pour déclencher les premières unités de commutation, dans lequel les capteurs de direction CC communiquent leurs signaux de sortie à l'unité de commande de combineur (ACCU),
**caractérisé en ce que**
que le boîtier de combinaison comprend l'unité de commande de combineur de réseaux (ACCU), et **en ce que** le boîtier de combinaison de réseaux (ACB) comprend une paire de secondes unités de commutation (358, 368), dont un élément (358) est agencé dans la seconde connexion de ligne d'alimentation (354) et dont un autre élément (368) est agencé dans la seconde connexion de ligne de retour (364), et dans lequel le boîtier de combinaison de réseaux (ACB) comprend en outre les m paires de premières unités de commutation (355, 365) et la paire de secondes unités de commutation (358, 368),
dans lequel l'unité de commande de combineur de réseaux (ACCU) est configurée pour communiquer un premier signal de déclenchement (T) aux premières unités de commutation (355, 365) pour ouvrir m-1 des m paires de premières unités de commutation afin d'interrompre les courants continus (IA2, IA3) entre chacune des m-1 entrées CC (32, 33) et les deux barres omnibus (35, 36) lorsque dans une entrée restante (31) des entrées CC, le courant continu passe d'un courant direct (IA1) à un premier courant inverse (IRA2, IRA3), et
dans lequel l'unité de commande de combineur de réseaux (ACCU) est configurée pour communiquer le premier signal de déclenchement (T) aux m-1 paires de premières unités de commutation (355, 365) et à la paire de secondes unités de commutation (358, 368) retardées dans le temps par rapport à la détection du premier courant inverse (IA2, IA3) afin d'ouvrir ces secondes unités de commutation et de couper un second courant inverse (IRA) distribué par la sortie CC (30), lorsque le premier courant inverse est toujours présent après le retard dans le temps, et
dans lequel le retard dans le temps est au moins aussi long que le temps nécessaire pour déconnecter une chaîne défectueuse (S3) et un boîtier de combinaison de chaînes (SCB1) d'un réseau défectueux (A1) qui peut être connecté au moyen d'un câble (C1) à l'entrée CC restante (31) du boîtier de combinaison de réseaux (ACB), et
dans lequel l'unité de commande de combineur de réseaux (ACCU) est configurée pour communiquer un second signal de déclenchement pour ouvrir la première paire d'unités de commutation (355, 365) associées à l'entrée CC (31) avec un premier retard, dans lequel le premier retard est au moins le temps nécessaire pour couper le second courant inverse (IR0 ; IRA) ou dans lequel le premier retard est configuré pour correspondre à la décharge des condensateurs de filtrage de l'onduleur (K).

3. Boîtier de combinaison selon la revendication 1 ou 2,
**caractérisé en ce que**
chaque élément de la paire de secondes unités de commutation (258, 268, 358, 368) est réalisé sous la forme d'un disjoncteur ou d'un sectionneur électromécanique.

4. Boîtier de combinaison selon l'une quelconque des revendications 1 à 3,
**caractérisé en ce que**
l'unité de commande de combineur est en outre configurée pour
communiquer un troisième signal de déclenchement pour fermer les n-1 ou m-1 paires de premières unités de commutation et la paire de secondes unités de commutation avec un second retard afin de reconnecter les n-1 ou m-1 entrées CC (21, 22, 24, 32, 33) et la sortie CC (20 ; 30) aux deux barres omnibus (25, 26 ; 35, 36), dans lequel le second retard est au moins le temps nécessaire pour ouvrir la paire de premières unités de commutation associées à l'entrée CC restante (23 ; 31).

5. Boîtier de combinaison selon l'une quelconque des revendications 1 à 4,
**caractérisé en ce que**
le boîtier de combinaison comprend une pluralité de n ou m paires de capteurs de direction CC, dans lequel chaque capteur est associé à l'une des premières unités de commutation.

6. Boîtier de combinaison selon l'une des revendications 1 à 5,
**caractérisé en ce que**
au moins un élément de chacune des n ou m paires de premières unités de commutation (255, 265, 355, 365) est réalisé sous la forme d'un disjoncteur hybride.

7. Boîtier de combinaison selon la revendication 6,
**caractérisé en ce que**
au moins un autre élément de chacune des n ou m paires de premières unités de commutation (255, 265, 355, 365) est réalisé sous la forme d'un sectionneur électromécanique.

8. Boîtier de combinaison selon l'une quelconque des revendications 1 à 7,
**caractérisé en ce que**
le boîtier de combinaison comprend en outre n ou m paires d'unités de commande locales (LCCU), dans lequel chaque unité locale est associée à l'une des premières unités de commutation (255, 265, 355, 365),
chaque capteur de direction CC (256, 266 ; 356, 366) communique ses signaux de sortie à au moins un élément associé d'une paire des n ou m paires d'unités de commande locales,
au moins un élément associé d'une paire des n ou m paires d'unités de commande locales communique les signaux de sortie du capteur de direction CC associé à l'unité de commande de combineur (SCCU ; ACCU), et
l'unité de commande locale (LCCU) communique le premier signal de déclenchement (T) et tout autre signal de données à la première unité de commutation associée.

9. Boîtier de combinaison selon la revendication 8,
**caractérisé en ce que**
l'unité de commande de combineur (SCCU) et chacune des unités de commande locales (LCCU) comprennent un élément de commande (RM) pour le retard et la libération du premier signal de déclenchement (T) et de tout autre signal de données.

10. Boîtier de combinaison selon l'une des revendications 8 ou 9,
**caractérisé en ce que**
le boîtier de combinaison comprend un agencement de rails (RA) et une pluralité de modules en forme de boîtier (MS11, MS12, MSCCU, M25, M26, MCB) fixés à l'agencement de rails (RA).

11. Boîtier de combinaison selon la revendication 10,
**caractérisé en ce que**
un premier module (MS11, MS12) de la pluralité de modules comprend une seule unité de commutation (255) des n ou m paires des premières unités de commutation, une section de la connexion de ligne d'alimentation (252) ou de retour passant par le premier module entre une borne d'entrée et une borne de sortie, un seul capteur de direction CC (256) desdits au moins n ou m capteurs de direction CC,
une unité de commande locale (LCCU) de la pluralité de n ou m paires d'unités de commande locales pour recevoir des signaux de données à partir du capteur de direction CC unique (256) et de l'unité de commutation unique (255) et pour transmettre des signaux de données à l'unité de commutation unique, et
une interface de données (IOL) pour communiquer des signaux de données (DS) entre son unité de commande logique (LCCU) et l'unité de commande de combineur (SCCU).

12. Boîtier de combinaison selon la revendication 1,
**caractérisé en ce que**
un capteur de potentiel-terre (257, 267) est agencé dans chacune des n premières connexions de ligne d'alimentation (252) et des n connexions de ligne de retour correspondantes (262).

13. Boîtier de combinaison selon la revendication 12,
**caractérisé en ce que**
les capteurs de potentiel-terre (257, 267) sont réalisés sous la forme de diviseurs de tension.

14. Partie CC d'une installation photovoltaïque comprenant au moins un boîtier de combinaison selon l'une quelconque des revendications 1 à 13.

15. Partie CC selon la revendication 14, dans laquelle ledit au moins un boîtier de combinaison comprend au moins un premier boîtier de combinaison qui est réalisée sous la forme d'un boîtier de combinaison de chaînes (SCB1, SCB2, SCB3) selon la revendication 1, et
un second boîtier de combinaison qui est réalisé sous la forme d'un boîtier de combinaison de réseaux (ACB) selon la revendication 2, dans laquelle chacune des m paires de premières unités de commutation (355, 365) comprend deux disjoncteurs électromécaniques,
dans lequel le second boîtier de combinaison (ACB) est connecté au premier boîtier de combinaison (SCB1, SCB2, SCB3) par l'intermédiaire de la sortie CC (31, 32, 33) du premier boîtier de combinaison (SCB1, SCB2, SCB3).
